# EUROPEAN PATENT APPLICATION

(11) **EP 2 398 048 A1**
(43) Date of publication of application: **21.12.2011**
(21) Application number: 10741084.7
(22) Date of filing: 10.02.2010
(51) Int. Cl.: H01L 23/00, C08F 290/06, H01L 21/301

(54) **SEMICONDUCTOR PROTECTION FILM-FORMING FILM WITH DICING SHEET, METHOD FOR MANUFACTURING SEMICONDUCTOR DEVICE USING SAME, AND SEMICONDUCTOR DEVICE**

(30) Priority: 12.02.2009 JP 2009029361; 01.07.2009 JP 2009156551; 20.01.2010 JP 2010010228
(71) Applicant: Sumitomo Bakelite Co., Ltd., Shinagawa-ku Tokyo 140-0002 (JP)
(72) Inventor: HIRANO, Takashi, Tokyo 140-0002 (JP); YOSHIDA, Masato, Tokyo 140-0002 (JP)
(74) Representative: Müller, Christian Stefan Gerd
(86) International application number: PCT/JP2010/000810
(87) International publication number: WO 2010/092804

(57) **Abstract**

The present invention includes a dicing sheet-attached film for forming a semiconductor protection film (14), which protects a semiconductor element (18) mounted on a base material and positioned on the outermost side. The dicing sheet-attached film for forming a semiconductor protection film (14) comprises a protection film-forming layer (12) which is composed of a resin composition and protects a surface of the semiconductor element (18) opposite to the surface of the semiconductor element (18) mounted on the base material, and a dicing sheet (13) laminated on the protection film-forming layer.

## Description

### TECHNICAL FIELD

The present invention relates to a dicing sheet-attached film for forming a semiconductor protection film, a method for producing a semiconductor device using the dicing sheet-attached film and a semiconductor device.

### BACKGROUND ART

In late years, miniaturization and lightweightness of a semiconductor device have been further promoted, and packages such as µBGA (Ball Grid Array), CSP (Chip Size Package) and the like have been developed. However, in packages such as µBGA, CSP and the like, a semiconductor element is a face-down type, which means that a circuit surface of the semiconductor element is directed toward a semiconductor substrate side, so that a back surface of the semiconductor element is exposed on the top of the package, thus causing a problem of cracking the end portion of the semiconductor element when a package is produced or is conveyed. In order to solve the problem, a method of bonding a protection film to a back surface of the semiconductor element has been disclosed (for example, refer to Patent Documents 1 to 3).

### RELATED DOCUMENTS

### PATENT DOCUMENTS

Patent Document 1: Japanese Patent Laid-Open No. 2002-280329
Patent Document 2: Japanese Patent Laid-Open No. 2004-214288
Patent Document 3: Japanese Patent Laid-Open No. 2007-250970

### DISCLOSURE OF THE INVENTION

However, the technique according to the above documents comprises a step of laminating a protection film-forming layer with a semiconductor wafer and then bonding the laminate to a dicing sheet, so that there is a problem in that the production process of a semiconductor device is complicated.

The present invention has been accomplished in view of the above circumstances, and an object thereof is to enhance the reliability of a semiconductor device by forming a protection film on a surface of the semiconductor element opposite to a base material-mounted surface of the semiconductor element of the topmost layer without lowering the throughput of the production process.

According to the present invention, there is provided a dicing sheet-attached film for forming a semiconductor protection film to be used for protecting a semiconductor element mounted on a base material and positioned on the outermost side, comprising a protection film-forming layer composed of a resin composition for protecting a surface of said semiconductor element opposite to the surface mounted on said base material, and a dicing sheet laminated on said protection film-forming layer.

Furthermore, according to the present invention, there is also provided a method for producing a semiconductor device having a semiconductor protection film on a surface of a semiconductor element mounted on a base material and positioned on the outermost side opposite to the surface mounted on said base material, comprising:
laminating a semiconductor wafer on said protection film-forming layer side of the film for forming a semiconductor protection film having a protection film-forming layer composed of said semiconductor protection film and a dicing sheet so as to be in contact with the semiconductor element surface opposite to the surface mounted on said base material;
dicing said semiconductor wafer into a predetermined size along with said protection film-forming layer; and
obtaining the semiconductor element having said semiconductor protection film formed thereon by peeling off said dicing sheet from said protection film-forming layer.

According to the present invention, there is also provided a semiconductor device manufactured by the aforementioned method for producing a semiconductor device.

According to the present invention, the dicing sheet-attached film for forming a semiconductor protection film of the present invention is configured such that the dicing sheet is previously laminated to the protection film-forming layer. Therefore, the protection film-forming layer is bonded to the surface of the semiconductor element opposite to the base material-mounted surface, whereby the dicing sheet is attached to a semiconductor wafer. Accordingly, a step of bonding a dicing sheet is shortened and the surface of the semiconductor element opposite to the base material-mounted surface is protected, so that the reliability of the semiconductor device can be enhanced.

According to the present invention, the reliability of the semiconductor device can be enhanced without lowering the throughput of the production process of the semiconductor device.

### BRIEF DESCRIPTION OF THE DRAWINGS

The above and other objects, features and advantages will be apparent from the following detailed description of the preferred embodiments in conjunction with the accompanying drawings.

Fig. 1 is a view illustrating a process of producing a semiconductor device using a dicing sheet-attached film for forming a semiconductor protection film according to the first and third embodiments.
Fig. 2 is a view illustrating a process of producing a semiconductor device using a dicing sheet-attached film for forming a semiconductor protection film according to the second embodiment.

### DESCRIPTION OF EMBODIMENTS

The present invention relates to a dicing sheet-attached film for forming a semiconductor protection film to be used for protecting a surface of a semiconductor element mounted on a base material and positioned on the outermost side opposite to the surface mounted on the base material. This dicing sheet-attached film for forming a semiconductor protection film comprises a protection film-forming layer composed of a resin composition and a dicing sheet laminated on the protection film-forming layer. In present invention, examples of the base material include a resin substrate and a structure obtained by laminating a plurality of semiconductor elements on the resin substrate.

It is preferable that the resin composition constituting the protection film-forming layer contains at least a thermosetting component (A) and an inorganic filler (B).

The thermosetting component (A) is a resin which is thermally cured alone or a resin which is thermally cured with a curing agent, and is not particularly limited. Examples thereof include a bisphenol type epoxy resin such as a bisphenol A epoxy resin, a bisphenol F epoxy resin and the like; a novolac type epoxy resin such as a novolac epoxy resin, a cresol novolac epoxy resin and the like; an epoxy resin such as a biphenyl type epoxy resin, a stilbene type epoxy resin, a triphenolmethane type epoxy resin, an alkyl-modified triphenolmethane type epoxy resin, an epoxy resin containing a triazine nucleus, a dicyclopentadiene-modified phenol type epoxy resin, a glycidylamine type epoxy resin and the like; a resin containing a triazine ring such as an urea resin, a melamine resin and the like; an unsaturated polyester resin; a bismaleimide resin; a polyurethane resin; a diallylphthalate resin; a silicon resin; a resin having a benzoxazine ring; a cyanate ester resin; a modified phenoxy resin and the like. These resins may be used either individually or in combination of two or more kinds. Among these resins, preferably used is an epoxy resin in view of an excellent balance between the heat resistance of the protection film-forming layer and adhesiveness to an adherend (semiconductor element).

The inorganic filler (B) is not particularly limited, and examples thereof include silica, aluminum oxide, calcium carbonate, magnesium carbonate, aluminum nitride and the like. These may be used either individually or in combination of two or more kinds. The content of the inorganic filler (B) is preferably 10 % by mass or more and 95 % by mass or less, based on the total amount of the protection film-forming layer. When the content is within the above range, a protection film-forming layer excellent in the thermal time elastic modulus can be obtained.

The resin composition constituting the protection film-forming layer may contain a coloring agent (C). The coloring agent (C) is not particularly limited, and examples thereof include carbon black, graphite, carbon titanium, titanium dioxide, and phthalocyanine pigments or dyes.

The dicing sheet is not particularly limited. As the dicing sheet, those having an adhesive layer laminated on a base film of polyolefin, polyester or vinyl chloride may be used. The adhesive layer may contain an acrylic adhesive agent, a rubber adhesive agent or the like. Examples of the acrylic adhesive agent include a resin composed of (meth)acrylic acid and ester thereof, a copolymer of (meth)acrylic acid and ester thereof with an unsaturated monomer (for example, vinyl acetate, styrene, acrylonitrile or the like) copolymerizable with these, and the like. These resins may be used in mixture of two or more kinds.

Hereinafter, the dicing sheet-attached film for forming a semiconductor protection film of the present invention will be described in detail.

### First Embodiment

The dicing sheet-attached film for forming a semiconductor element protection film of this embodiment is **characterized in that** a dicing sheet is laminated with a protection film-forming layer formed on one side of the dicing sheet. The protection film-forming layer (the film for forming a semiconductor protection film) protects a surface of a semiconductor element mounted on a base material such as a substrate or the like and positioned on the outermost side opposite to the surface mounted the above-mentioned base material such as a substrate or the like. The resin composition constituting the protection film-forming layer comprises a thermosetting component (A) and an energy ray curing component (D), and accordingly protects the semiconductor element so as not to cause cracking or the like. Furthermore, the semiconductor device of this embodiment is a semiconductor device in which a surface of a semiconductor element mounted on a base material such as a substrate or the like and positioned on the outermost side opposite to the surface mounted on said base material such as a substrate or the like is protected by a semiconductor protection film, wherein the semiconductor protection film is composed of a cured product of the aforementioned protection film-forming layer, and it is accordingly possible to prevent collet traces or scratches from being caused when the semiconductor element is mounted on the base material such as a substrate or the like by means of a flip chip bonder or the like. Hereinafter, the dicing sheet-attached film for forming a semiconductor protection film of this embodiment, the semiconductor device and the method for producing a semiconductor device will be described each in detail.

The lower limit of the weight average molecular weight of the resin component in the resin composition constituting the protection film-forming layer is preferably not less than 100 and more preferably not less than 200. The upper limit of the weight average molecular weight of the resin component in the resin composition constituting the protection film-forming layer is preferably not more than 49,000 and more preferably not more than 40, 000. When the weight average molecular weight of the resin component is within the above range, it allows the protection film-forming layer to have a high glass transition temperature after curing while maintaining film forming properties.

The resin composition constituting the protection film-forming layer (hereinafter referred to as the film resin composition) of this embodiment may contain an energy ray curing component (D). The energy ray curing component (D) is a compound which is cured when it is irradiated with energy ray such as ultraviolet light, electron beam or the like, and a compound having at least one polymerizable double bond in a molecule. More specifically, a compound which is cured by energy ray having a wavelength of 200 nm or more and 500 nm or less is preferably used as the energy ray curing component.

In this embodiment, as the energy ray curing component (D), preferably used is a compound (D1) having a hydroxyl group or a carboxyl group and a (meth) acryloyl group. The hydroxyl group or the carboxyl group of the compound (D1) is a group capable of reacting with the epoxy group when a compound having an epoxy group is used as the thermosetting component (A), and the (meth)acryloyl group is a group capable of not only curing the compound by energy ray, but also reacting with an epoxy group when a compound having an epoxy group is used as the thermosetting component (A). By use of these groups, the compound (D1) can be cured with both energy ray and heat, when a compound having an epoxy group is used as the thermosetting component (A).

The weight average molecular weight of the compound (D1) is preferably 200 or more and 49,000 or less, more preferably 200 or more and 30,000 or less, further preferably 300 or more and 10,000 or less, and particularly preferably 1, 000 or more and 8, 000 or less. When the weight average molecular weight of the compound (D1) is within the above range, the resin composition may have high reactivity to energy ray. Incidentally, the weight average molecular weight in this embodiment is measured by GPC (gel permeation chromatography) and converted into polystyrene molecular weight.

The number of (meth) acryloyl groups in one molecule of the compound (D1) is preferably 1 to 40 and more preferably 2 to 30. When the number of (meth) acryloyl groups in one molecule of the compound (D1) is within the above range, tackiness is reduced after an irradiation with energy ray, and heat resistance of the cured product is increased.

Examples of the compound (D1) include, though not restricted to, a compound (D11) having a dibasic acid introduced into the molecular chain of a (meth)acryloyl-modified epoxy resin having a (meth)acryloyl group introduced into both ends of the epoxy resin, wherein, in this compound, a hydroxyl group in the molecular chain of the (meth)acryloyl-modified epoxy resin is bonded to one of the carboxyl groups among the dibasic acids through an ester bond (the number of epoxy resin repeating units in the compound is 1 or more, and the number of dibasic acids introduced into the molecular chain is 1 or more); a (meth)acryloyl-modified bisphenol (D12); a (meth)acrylic acid polymer (D13) having a carboxyl group and a (meth)acryloyl group; a (meth)acryloyl-modified novolac type phenol resin (D14); and the like. Among these compounds, preferably used are the (meth)acryloyl-modified bisphenol (D12), the (meth)acrylic acid polymer (D13) having a carboxyl group and a (meth)acryloyl group, the (meth)acryloyl-modified novolac type phenol resin (D14) from the viewpoint of excellent heat resistance of the protection film-forming layer after curing, and particularly preferably used are the (meth)acryloyl-modified bisphenol (D12) and the (meth)acryloyl-modified novolac type phenol resin (D14).

The compound (D11) having a dibasic acid introduced into the molecular chain of a (meth)acryloyl-modified epoxy resin having a (meth)acryloyl group introduced into both ends of the epoxy resin, wherein, in this compound, a hydroxyl group in the molecular chain of the (meth)acryloyl-modified epoxy resin is bonded to one of the carboxyl groups among the dibasic acids through an ester bond (the number of epoxy resin repeating units in the compound is 1 or more, and the number of dibasic acids introduced into the molecular chain is 1 or more) may be obtained, for example, by polymerizing epichlorohydrin and a polyhydric alcohol to produce an epoxy resin, reacting the epoxy groups on both ends of the resulting epoxy resin with a (meth)acrylic acid to obtain a (meth)acryloyl-modified epoxy resin having a (meth)acryloyl group introduced into both ends of the epoxy resin, and then reacting a dibasic acid anhydride with a hydroxyl group in the molecular chain of the resulting (meth)acryloyl-modified epoxy resin to form an ester bond with one of the carboxyl groups among the dibasic acids. As the compound (D11), for example, an acid-modified vinyl epoxy resin or the like is cited.

Furthermore, the (meth)acryloyl-modified bisphenol (D12) may be obtained, for example, by reacting one hydroxyl group of bisphenols with an epoxy group of a compound having an epoxy group and a (meth) acryloyl group. As the (meth)acryloyl-modified bisphenol (D12), for example, a (meth)acryloyl-modified bisphenol A represented by the following formula (2) or the like is exemplified,

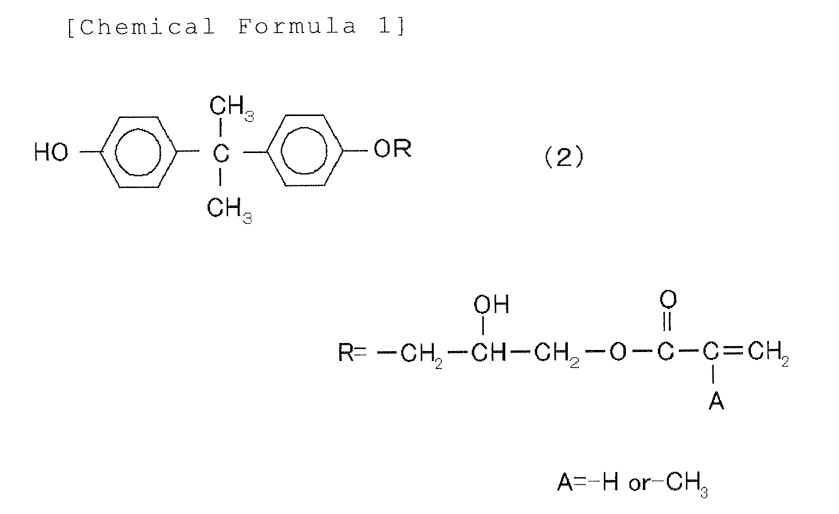

Examples of the (meth) acrylic acid polymer (D13) having a carboxyl group and a (meth)acryloyl group (the number of (meth) acrylic acid repeating units is 2 or more) include a compound obtained by substituting some of the acid groups (-COOH) of the (meth)acrylic acid polymer represented by the following general formula (3) with a group represented by the following general formula (4),

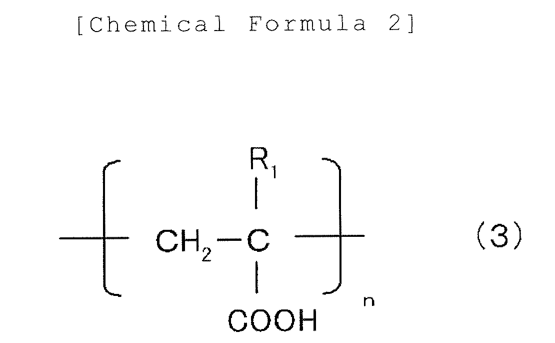

wherein, in the formula, R₁ is a hydrogen atom or an alkyl group; and n is an integer of 2 to 10,

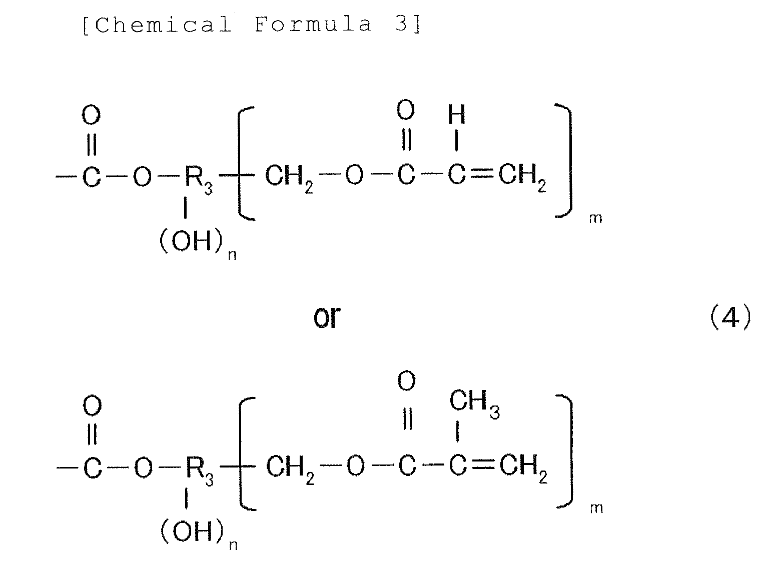

wherein, in the formula, R₃ is a benzene ring or a cyclohexane ring; m is 1 or 2; and n is 0 to 2.

Meanwhile, in the (meth)acrylic acid polymer (D13) having a carboxyl group and a (meth)acryloyl group, some of the acid groups may be substituted with an alkyl ester or a hydroalkyl ester. The above (meth)acrylic acid polymer (D13) having a carboxyl group and a (meth) acryloyl group is one example, and is not particularly limited. As the compound (D13), for example, an acrylic acid polymer containing a carboxyl group and a methacryloyl group or the like is exemplified.

Furthermore, the (meth)acryloyl-modified novolac type phenol resin (D14) refers to a novolac type phenol resin obtained by substituting some of the hydroxyl groups of the novolac type phenol resin with a group represented by the following formula (5).

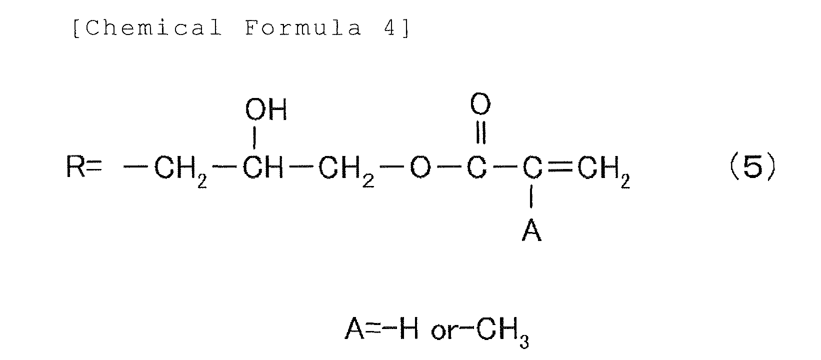

Moreover, in this embodiment, when two or more phenol compounds are polymerized via a methylene group, such a compound is referred to as the "resin" such as a novolac type phenol resin, and an unpolymerized monomer is referred to as the "phenol compound". The novolac type phenol resin described in the present invention is a generic term including a resin in which the phenol compound forming the molecular chain has one phenolic hydroxyl group such as phenol, cresol and the like, two phenolic hydroxyl groups such as bisphenol A, bisphenol F, catechol, resorcinol and the like, or three or more phenolic hydroxyl groups such as pyrogallol and the like, or is a mixture of these phenol compounds. Among the novolac type phenol resins, a polymer of phenol (C₆H₅OH) is referred to as the "novolac type phenol resin (phenol polymer)".

Examples of the phenol compound forming the molecular chain of the (meth)acryloyl-modified novolac type phenol resin (D14) include phenol, cresol, naphthol, hydroquinone, bisphenol A, bisphenol F, bisphenol E, bisphenol Z, bisphenol AF, bisphenol S, tetramethyl bisphenol F, tetramethyl bisphenol A, biphenol, diallyl bisphenol A, fluorenone bisphenol, pyrogallol and the like. Among these, preferably used are phenol, cresol, bisphenol F and bisphenol A. From the viewpoint of an excellent balance between the heat resistance of the protection film-forming layer after curing and the reliability of the semiconductor device, preferably used are phenol and bisphenol A.

The (meth)acryloyl-modified novolac type phenol resin (D14) is not particularly limited, and it may be a resin obtained by the addition reaction of a hydroxyl group of a novolac type phenol resin, which is obtained by reacting a phenol compound with formaldehyde, with an epoxy group of a (meth)acrylate having an epoxy group, or the like.

As the (meth)acryloyl-modified novolac type phenol resin (D14), from the viewpoint of an excellent balance of high reactivity to heat and energy ray, particularly preferably used is a (meth)acryloyl-modified novolac type bisphenol A resin obtained by substituting some of the hydroxyl groups of the novolac type bisphenol A resin represented by the following general formula (1) with (meth)acryloyl,

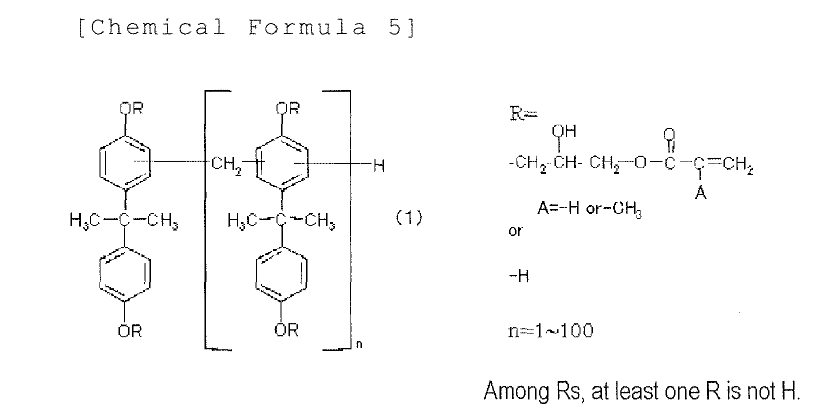

wherein, in the formula (1), n is an integer of 1 to 100 and more preferably an integer of 2 to 15.

The compounds (D1) may be used either individually or in combination of two or more kinds. The content of the compound (D1) is preferably 10 % by mass or more and 60 % by mass or less and particularly preferably 20 % by mass or more and 50 % by mass or less, based on the total amount of the film resin composition. When the content of the compound (D1) is within the above range, the heat resistance of the protection film-forming layer after curing can be enhanced. The content of the compound (D1) of the film resin composition of the present invention in the form of a varnish in which the constituent components are dissolved or dispersed in a solvent indicates the percentage of the compound (D1) relative to the total amount of the components (A) and (D) and an inorganic filler (B) and other additives to be added as necessary, excluding the solvent.

In this embodiment, for the purpose of improvement in the sensitivity, as the energy ray curing component (D), such energy ray curing components described below (hereinafter referred to as the energy ray curing component (D2)) may be used together, in addition to the compound (D1). Examples thereof include (meth)acrylates such as a monofunctional (meth)acrylate having one (meth)acryloyl group, a bifunctional (meth)acrylate having two (meth)acryloyl groups and a polyfunctional (meth) acrylate having three or more (meth) acryloyl groups. Further specific examples include bifunctional (meth) acrylates such as ethylene glycol di (meth) acrylate, 1,6-hexanediol di(meth)acrylate, glycerine di(meth)acrylate, 1,10-decanediol di(meth)acrylate and the like; and polyfunctional (meth)acrylates such as trimethylolpropane tri(meth)acrylate, pentaerythritol tri(meth)acrylate, dipentaerythritol hexa(meth)acrylate and the like. Examples also include polyalkylene glycol di(meth)acrylates such as polyethylene glycol di(meth)acrylate, polypropylene glycol di(meth)acrylate and the like. Urethane (meth)acrylate, epoxy (meth)acrylate and the like can also be exemplified as the compound.

Urethane (meth)acrylate refers to a compound which is obtained by producing a urethane compound by forming a urethane bond by the reaction of a hydroxyl group of a polyol with one isocyanate group of a compound having two or more isocyanate groups, and then reacting the isocyanate groups in the resulting urethane compound which have not been used for the reaction with the polyol and the hydroxyl group of a compound having a hydroxyl group and a (meth)acryloyl group to form a urethane bond.

Epoxy acrylate refers to a compound which is obtained by reacting an epoxy group in the epoxy resin with a carboxyl group in the compound having a carboxyl group and a (meth)acryloyl group to form an ester bond.

Examples of the urethane (meth)acrylate include a compound obtained by adding 2-hydroxyethyl (meth)acrylate to a urethane compound which is obtained by the reaction of polyalkylene glycol with diisocyanate. Examples of the epoxy (meth)acrylate include a compound obtained by reacting an epoxy group on both ends of an epoxy resin such as a bisphenol A type epoxy resin or a bisphenol F type epoxy resin with a carboxyl group of (meth)acrylic acid to form an ester bond.

Among these compounds, preferably used are bifunctional (meth)acrylates such as triethylene glycol di(meth)acrylate, 1,6-hexanediol di(meth)acrylate, glycerin di(meth)acrylate, 1,10-decanediol di(meth)acrylate and the like, from the viewpoint of an excellent balance between the photocurability and toughness of the protection film-forming layer, and particularly preferably used is triethylene glycol di(meth)acrylate.

The weight average molecular weight of the energy ray curing component (D2) which is used together with the compound (D1) is not more than 3,000, preferably 100 or more and 2,500 or less and particularly preferably 200 or more and 2, 000 or less. When the weight average molecular weight of the compound is within the above range, the energy ray curability can be improved.

The content of the energy ray curing component (D2) which is used together with the compound (D1) is preferably 3 % by mass or more and 30 % by mass or less, and particularly preferably 5 % by mass or more and 20 % by mass or less, based on the total amount of the film resin composition. When the content of the energy ray curing component (D2) which is used together with the compound (D1) is within the above range, the energy ray curing reactivity and toughness of the protection film-forming layer can be improved. The content of the energy ray curing component (D2) which is used together with the compound (D1) of the film resin composition in the form of a varnish in which constituent components are dissolved or dispersed in a solvent indicates the percentage of the energy ray curing component (D2) relative to the total amount of the components (A) and (D), and the inorganic filler (B) and other additives to be added as necessary, excluding the solvent.

In the film resin composition, a photoinitiator may be added in order to reduce the amount of irradiation with energy ray. Such a photoinitiator is not particularly limited, and examples thereof include benzophenone, acetophenone, benzoin, benzoin isobutyl ether, methyl benzoin benzoate, benzoin benzoate, benzoin methyl ether, benzyl phenyl sulfide, benzyl dimethyl ketal, dibenzyl dimethyl ketal and the like.

The content of the photoinitiator is preferably 0.5 % by mass or more and 5 % by mass or less, and particularly preferably 0.8% by mass or more and 2.5 % by mass or less, based on the total amount of the film resin composition. When the content of the photoinitiator is within the above range, the photoinitiator can maintain a balance between the photocurability and storage stability. The content of the photoinitiator of the film resin composition in the form of a varnish in which constituent components are dissolved or dispersed in a solvent indicates the percentage of the photoinitiator relative to the total amount of the components (A) and (D), and the inorganic filler (B) and other additives to be added as necessary, excluding the solvent.

The film resin composition may contain a thermosetting component (A). In this embodiment, the thermosetting component (A) is a resin which is thermally cured alone, or a resin which is thermally cured with the aforementioned compound (D1) or a curing agent. The thermosetting component (A) is not particularly limited, and those as aforementioned above may be used. Among these, preferably used is an epoxy resin, in view of excellent reactivity with the compound (D1), or an excellent balance between the heat resistance of the protection film-forming layer and adhesiveness to the adherend. Furthermore, a compound which is not cured by energy ray of a wavelength of 200 nm or more and 500 nm or less is preferably used as the thermosetting component (A).

The weight average molecular weight of the thermosetting component (A) is preferably 200 or more and 10,000 or less, and particularly preferably 300 or more and 5,000 or less. When the weight average molecular weight of the thermosetting component (A) is within the above range, both high reactivity during thermal curing and high protection ability to the adherend can be achieved.

The content of the thermosetting component (A) is preferably 10 % by mass or more and 40 % by mass or less, and particularly preferably 15 % by mass or more and 35 % by mass or less, based on the total amount of the film resin composition. When the content of the thermosetting component (A) is within the above range, both the heat resistance and toughness of the protection film-forming layer after curing can be achieved. The content of the thermosetting component (A) of the film resin composition in the form of a varnish in which constituent components are dissolved or dispersed in a solvent indicates the percentage of the thermosetting component (A) relative to the total amount of the components (A) and (D), and the inorganic filler (B) and other additives to be added as necessary, excluding the solvent.

When the epoxy resin is used as the thermosetting component (A), the epoxy resin is not particularly limited, but it is preferable that it may further contain a curing catalyst as described above, which improves the curability of the protection film-forming layer. Examples of the curing catalyst include imidazoles; amine catalysts such as 1,8-diazabicyclo(5,4,0)undecene and the like; and phosphorus catalysts such as triphenylphosphine and the like. Among these, preferably used are imidazoles, which exhibit both the rapid curability and storage stability of the protection film-forming layer. When an epoxy resin is used as the thermosetting component (A), a curing agent such as a phenol novolac resin or the like may also be used together, in addition to the aforementioned compound (D1).

Imidazoles are not particularly limited, but examples thereof include 1-benzyl-2-methyl imidazole, 1-benzyl-2-phenyl imidazole, 1-cyanoethyl-2-ethyl-4-methyl imidazole, 2-phenyl-4-methyl imidazole, 1-cyanoethyl-2-phenyl imidazolium trimellitate, 2,4-diamino-6-[2'-methylimidazolyl-(1')]-ethyl-s-triaz ine, 2,4-diamino-6-[2'-undecylimidazolyl-(1')]-ethyl-s-triazine, 2,4-diamino-6-[2'-ethyl-4'methylimidazolyl-(1')]-ethyl -s-triazine, 2,4-diamino-6-[2'-methylimidazolyl-(1')]-ethyl-s-triaz ine isocyanurate adduct, 2-phenylimidazole isocyanurate adduct, 2-phenyl-4,5-dihydroxy methyl imidazole, 2-phenyl-4-methyl-5-hydroxy methyl imidazole, 2,4-diamino-6-vinyl-s-triazine, 2,4-diamino-6-vinyl-s-triazine isocyanurate adduct, 2,4-diamino-6-methacryloxyethyl-s-triazine, 2,4-diamino-6-methacryloxyethyl-s-triazine isocyanurate adduct and the like. Among these, preferably used are 2-phenyl-4,5-dihydroxy methyl imidazole and 2-phenyl-4-methyl-5-hydroxymethyl imidazole, from the viewpoint of an excellent balance between the rapid curability and storage stability of the protection film-forming layer.

In this embodiment, the content of the curing catalyst is not particularly limited, but it is preferably 0.01 parts by mass or more and 30 parts by mass or less, and particularly preferably 0.5 parts by mass or more and 10 parts by mass or less, based on 100 parts by mass of the epoxy resin. When the content is within the above range, the protection film-forming layer can achieve both the rapid curability and storage stability.

The average particle size of the curing catalyst is not particularly limited, but it is preferably not more than 10 µm and particularly preferably 1 µm or more and 5 µm or less. When the average particle size is within the above range, the rapid curability of the protection film-forming layer can be ensured.

In this embodiment, the film resin composition may contain an inorganic filler (B). The inorganic filler (B) is not particularly limited, and those as mentioned above may be used. Among these, particularly preferably used is spherical silica having an average particle size of 1 nm or more and 500 nm or less. Examples of silica include precipitated silica, fumed silica, colloidal silica and the like. Among these, preferably used is colloidal silica. Since the level of the contamination with metal in the colloidal silica is lower than that of the precipitated silica and the fumed silica, the use of the colloidal silica allows reducing ionic impurities in the protection film-forming layer. In addition, since the colloidal silica is formed of silica dispersed in a solvent in a condition of substantially monodispersion, the blending of the film resin composition into the resin varnish allows reducing the agglomeration of the silica.

The average particle size of silica is preferably 1 nm or more and 500 nm or less, and particularly preferably 10 nm or more and 30 nm or less, in view of improvement in the elastic modulus, and particularly preferably 100 nm or more and 500 nm or less, in view of laser marking property. When the average particle size is within the above range, the protection film-forming layer excellent in the thermal time elastic modulus and laser marking property can be obtained. The average particle size of silica is measured in the following manner. Silica is ultrasonically dispersed in water for 1 minute and the average particle size is measured using a laser diffraction type particle size distribution measuring device SALD-7000 (commercially available from Shimadzu Corporation). The value of D50 (integrated number) is taken as the average particle size.

The content of the inorganic filler (B) is preferably 10 % by mass or more and 60 % by mass or less, and particularly preferably 20 % by mass or more and 40 % by mass or less, based on the total amount of the protection film-forming layer. When the content is within the above range, the protection film-forming layer excellent in the thermal time elastic modulus can be obtained.

In this embodiment, the film resin composition may contain a coloring agent (C). The coloring agent is not particularly limited, and for example, those as mentioned above may be used. The content of the coloring agent (C) is preferably 0.1 % by mass or more and 10 % by mass or less, and particularly preferably 0.2 % by mass or more and 5 % by mass or less, based on the total amount of the film resin composition. When the content of the coloring agent is not more than 0.1 % by mass, coloring is not sufficient and the visibility after laser marking tends to be lowered. When it exceeds 10 % by mass, the elastic modulus and heat resistance of the protection film-forming layer may possibly be deteriorated.

The film resin composition is not particularly limited, but it may further contain a coupling agent. Accordingly, this allows providing further improved adhesiveness in the interface between the protection film-forming layer and the adherend (semiconductor element). Examples of the coupling agent include a silane coupling agent, a titanate coupling agent, an aluminum coupling agent and the like. Preferably used is a silane coupling material excellent in heat resistance of the protection film-forming layer after curing.

The silane coupling agent is not particularly limited, and examples thereof include vinyl trichlorosilane, vinyl trimethoxysilane, vinyl triethoxysilane, β-(3,4-epoxycyclohexyl)ethyl trimethoxysilane, γ-glycidoxypropyl trimethoxysilane, γ-glycidoxypropylmethyl dimethoxysilane, γ-methacryloxypropyl trimethoxysilane, γ-methacryloxypropylmethyl diethoxysilane, γ-methacryloxypropyl triethoxysilane, N-β(aminoethyl)γ-aminopropylmethyl dimethoxysilane, N-β(amznoethyl)γ-aminopropyl trimethoxysilane, N-β(aminoethyl)γ-aminopropyl triethoxysilane, γ-aminopropyl trimethoxysilane, γ-aminopropyl triethoxysilane, N-phenyl-γ-aminopropyl trimethoxysilane, γ-chloropropyl trimethoxysilane, γ-mercaptopropyl trimethoxysilane, 3-isocyanatepropyl triethoxysilane, 3-acryloxypropyl trimethoxysilane and the like. These may be used either individually or in combination of two or more kinds.

The content of the coupling agent is not particularly limited, but it is preferably 0.01 parts by mass or more and 10 parts by mass or less, and particularly preferably 0.5 parts by mass or more and 10 parts by mass or less, based on 100 parts by mass of the thermosetting component (A). When the content is within the above range, an effect of excellent adhesiveness to the adherend (semiconductor element) is obtained.

In this embodiment, the film resin composition may contain additives such as a plastic resin, a leveling agent, an antifoaming agent, organic peroxide or the like, in the ranges in which the object of the present invention is not damaged.

The method for producing a dicing sheet-attached film for forming a semiconductor protection film of this embodiment is not particularly limited, and the film can be produced, for example, in the following manner.
First, respective components such as the aforementioned components (A), (B), (C), (D) and other additives are dissolved or dispersed in a solvent such as an organic solvent, for example, methyl ethyl ketone, acetone, toluene, dimethylformamide or the like to be a varnish-like condition.

Next, the varnish-like film resin composition is applied to the base film with a comma coater, a die coater, a gravure coater and the like. The thickness of the protection film-forming layer is not particularly limited, but it is preferably 3 µm or more and 100 µm or less, and particularly preferably 5 µm or more and 60 µm or less. When the thickness is within the above range, the thickness accuracy of the protection film-forming layer can be easily controlled.

Herein, the base film is a film support base material having film characteristics for maintaining the film state of the protection film-forming layer, namely, for example, better breaking strength and better flexibility. The base film preferably has light transmission. Examples of the base film include polyethylene terephthalate (PET), polypropylene (PP), polyethylene (PE) and the like. Preferably used is polyethylene terephthalate (PET), in view of an excellent balance between the light transmission and breaking strength.

The protection film-forming layer in the form of a film is formed on the base film by forming the film resin composition on the surface of the base film in the form of a layer, and then drying the film to remove the solvent.

A cover film may be arranged on the surface of the thus-formed protection film-forming layer in order to protect the protection film-forming layer. The cover film may be good as long as it is a material having film characteristics for maintaining the film state of the protection film-forming layer, namely, for example, better breaking strength and better flexibility, particularly excellent peeling properties of the protection film-forming layer. Examples thereof include polyethylene terephthalate (PET), polypropylene (PP), polyethylene (PE) and the like. Incidentally, the cover film may be formed from a opaque material.

Thereafter, a dicing sheet-attached film for forming a semiconductor protection film is obtained, which is composed of a dicing sheet, a base film and a protection film-forming layer laminated in this order by bonding the dicing sheet to the base film.

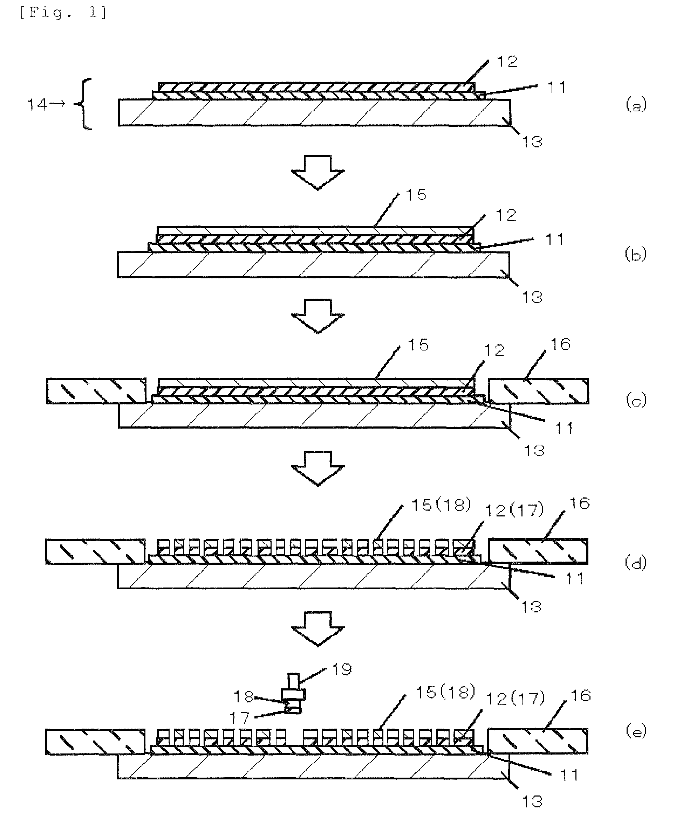

Subsequently, the method for producing a semiconductor device will be described with reference to Fig. 1. Fig. 1 is a flow chart for the production of a semiconductor device. As shown in Fig. 1, a dicing sheet 13, a base film 11 and a protection film-forming layer 12 are laminated to form a dicing sheet-attached film for forming a semiconductor protection film 14 which is disposed on a dicer table (not illustrated) (Fig. 1 (a)). The surface of a semiconductor wafer 15 side where a semiconductor element circuit is not formed is put on the protection film-forming layer 12 in the center, which is then lightly pressed to laminate the semiconductor wafer 15 (Fig. 1(b)).

Next, wafer rings 16 are arranged on the periphery of the semiconductor wafer 15. At this time, a periphery portion of the dicing sheet 13 is fastened by means of the wafer ring 16 (Fig. 1 (c)). The semiconductor wafer 15 is cut by means of a blade (not illustrated) along with the protection film-forming layer 12, whereby the semiconductor wafer 15 is diced into the respective pieces (Fig. 1 (d)). At this time, the dicing sheet-attached film for forming a semiconductor protection film 14 has a cushioning function, thus preventing the semiconductor wafer 15 from being broken or cracked during cutting of the semiconductor wafer 15. Incidentally, the semiconductor wafer 15 may be attached to the dicing sheet-attached film for forming a semiconductor protection film 14 in advance, and then placed on the dicer table.

Then, ultraviolet light (wavelength: 200 nm or more and 500 nm or less) is irradiated from the dicing sheet 13 side (lower side in Fig. 1 (d)), and the dicing sheet 13 is further stretched with an expanding device (not illustrated) in order to provide certain intervals between the respective diced semiconductor wafers 15 (semiconductor elements 18) and the protection film-forming layer 12 (a semiconductor protection film 17). Then, the semiconductor element 18 is mounted on the substrate using a flip chip bonder. Subsequently, the semiconductor element 18 is picked up with a collet 19, and the semiconductor element 18 having the semiconductor protection film 17 is peeled off from the dicing sheet 13 (Fig. 1 (e)). Then, the semiconductor element 18 having the semiconductor protection film 17 is turned upside down and mounted on the substrate (not illustrated) in a face-down manner.

Here, the protection film-forming layer 12 (semiconductor protection film 17) is subjected to further curing by an irradiation with ultraviolet light, so that adhesiveness to the base film 11 becomes lowered. Therefore, when the semiconductor element 18 is picked up, the protection film-forming layer 12 (semiconductor protection film 17) is peeled off from the base film 11, and the semiconductor protection film 17 is still attached to the respective diced semiconductor elements 18.

Subsequently, the substrate having the semiconductor element 18 mounted thereon is heated at a temperature or higher (for example, 200 °C or more and 280°C or less) which dissolves bumps for electrically bonding electrode pads of the semiconductor element 18 and electrode pads of the substrate in an oven or the like, whereby the semiconductor element 18 and the substrate are completely bonded. Thereafter, a liquid epoxy resin (an encapsulating resin) also called an underfill material is filled between the semiconductor element 18 and the substrate, and the resulting material is cured. The semiconductor protection film 17 is thermally cured simultaneously with curing the underfill material, whereby a semiconductor device having the semiconductor protection film 17 formed on the semiconductor element 18 is obtained. The obtained semiconductor device is composed of the mounting substrate, the semiconductor element 18 and the semiconductor protection film 17 which are laminated in this order. Incidentally, the underfill material and the semiconductor protection film 17 are thermally cured, and then may be subjected to laser marking.

The elastic modulus at 260°C of the protection film-forming layer 12 (semiconductor protection film 17) before curing and after an irradiation with ultraviolet light (wavelength: 200 nm or more and 500 nm or less) is preferably 0.01 MPa or more and 100 MPa or less. Accordingly, the back of the collet is prevented from being attached in a pick-up step. The elastic modulus at 260°C may be determined, for example, by measuring the dynamic viscoelasticity of the protection film-forming layer 12 before curing and after an irradiation with ultraviolet light in a tensile mode under conditions of a temperature elevation rate of 3°C/min and a frequency of 10 Hz using a dynamic viscoelasticity measuring device commercially available from Seiko Instruments Inc. and measuring the storage elastic modulus at 260°C.

According to the embodiment, a film for forming a semiconductor protection film excellent in protection ability of the semiconductor element and a semiconductor device having the semiconductor protection film formed by using the film can be obtained.

In Patent Document 1, since a binder polymer component was used for a protection film, there were problems such that the collet traces were attached and scratches were not fully prevented, when a semiconductor element composed of a protection film-forming layer having a low elastic modulus was mounted on a substrate using a flip chip bonder or the like. Also, in Patent Document 3, by use of a high molecular weight component having a weight average molecular weight of not less than 10 x10⁴ as a thermosetting component, there were the similar problems.

However, according to this embodiment, by use of an energy ray curing resin and a thermosetting component, only the energy ray curing resin is cured, thus improving workability with easy peeling off. On the other hand, because of maintenance of high elastic modulus, the collet traces can be prevented from being attached. Furthermore, adhesiveness to the semiconductor element can be increased by thermally curing after it is mounted on the substrate. Accordingly, a semiconductor device with high reliability can be obtained.

### Second Embodiment

The dicing sheet-attached film for forming a semiconductor element protection film of this embodiment is **characterized in that** a dicing sheet are laminated with a protection film-forming layer formed on one side of the dicing sheet. The protection film-forming layer (film for forming a semiconductor protection film) protects a surface of a semiconductor element mounted on a base material such as a substrate or the like and positioned on the outermost side opposite to the surface mounted the base material such as a substrate or the like. The protection film-forming layer contains at least an adhesive layer and a heat resistant film, and is **characterized in that** an adhesive layer side is bonded to a surface of the semiconductor element opposite to the surface mounted on the above-mentioned base material such as a substrate or the like, and accordingly protects the semiconductor element so as not to cause cracking or the like. Furthermore, the semiconductor device of this embodiment is a semiconductor device in which a surface of a semiconductor element mounted on a base material such as a substrate or the like and positioned on the outermost side opposite to the surface mounted on said base material such as a substrate or the like is protected by a semiconductor protection film, and is obtained by using the above-mentioned dicing sheet-attached film for forming a semiconductor protection film. Accordingly, it is possible to prevent collet traces or scratches from being caused when the semiconductor element is mounted on the substrate by means of a flip chip bonder or the like. Hereinafter, the dicing sheet-attached film for forming a semiconductor protection film of this embodiment, the semiconductor device and the method for producing a semiconductor device will be described each in detail.

The dicing sheet-attached film for forming a semiconductor protection film of this embodiment contains at least an adhesive layer, a heat resistant film and a dicing sheet. It is preferable that the dicing sheet in this embodiment contains an energy ray curing component. As the energy ray curing component mentioned herein, the same ones as the energy ray curing component (D) used for the protection film-forming layer, as described in the first embodiment, may be used.

The heat resistant film is not particularly limited. The elastic modulus at room temperature (23°C) of the heat resistant film is preferably 2 GPa or more and 30 GPa or less, and more preferably 4 GPa or more and 25 GPa or less. Accordingly, the back of the collet is prevented from being attached in a pick-up step and warping of a chip is reduced. The elastic modulus at room temperature (23°C) of the heat resistant film may be determined, for example, by measuring the dynamic viscoelasticity of the heat resistant film in a tensile mode under conditions of a temperature elevation rate of 3°C/min and a frequency of 10 Hz using a dynamic viscoelasticity measuring device commercially available from Seiko Instruments Inc. and is regarded as a value of the storage elastic modulus at room temperature (23°C). In order to increase the elastic modulus of the heat resistant film, it is preferable that the heat resistant film contains an inorganic filler.

The heat resistant film is not particularly limited. When the resin component of the resin composition constituting the heat resistant film (hereinafter referred to as the heat resistant resin composition) is a thermoplastic resin, its melting point is preferably not less than 250°C and more preferably not less than 280°C. Accordingly, deterioration of the heat resistant film caused by solder reflow can be prevented. The upper limit is particularly not limited, but it is, for example, 700°C.

The heat resistant film is not particularly limited, but preferably used are those having laser marking property. Laser marking property refers to the visibility when letters, marks or the like are engraved using a laser. Accordingly, identification information of the semiconductor can be clearly displayed.

The heat resistant film is not particularly limited as long as it satisfies the numerical ranges of the aforementioned elastic modulus and the melting point, and examples include heat resistant films containing a heat resistant resin such as polyester, polyimide, polyetherimide, polyphenylene sulfide, an aramid resin, polyethylene terephthalate and the like; and heat resistant films obtained by immersing a varnish-like heat resistant resin composition containing a thermosetting resin such as an epoxy resin, a polyamide resin, a cyanate resin or the like in a film-like air-permeable cloth such as glass cloth, carbon fiber cloth, polyaramid fiber cloth or the like, and heating and drying the resulting material.

It is preferable that the heat resistant film contains a coloring agent (C) in consideration of laser marking property. As the kind of the coloring agent (C), those as described above may be used. The content of the coloring agent (C) is not particularly limited, but it is preferably 0.1 % by mass or more and 10 % by mass or less, and particularly preferably 0.2 % by mass or more and 5 % by mass or less, based on the total amount of the heat resistant resin composition. When the content of the coloring agent (C) is less than the above lower limit, coloring is not sufficient and the visibility after laser marking tends to be lowered. When it exceeds the above upper limit, the elastic modulus and heat resistance of the heat resistant film may possibly be deteriorated.

When a heat resistant film having a thermosetting resin immersed in a film-like air-permeable cloth is used as the heat resistant film, as the thermosetting resin used for the resin composition constituting the heat resistant film (hereinafter referred to as the heat resistant resin composition), preferably used are an epoxy resin and a cyanate resin. Examples of the epoxy resin include a biphenylene methylene type epoxy resin, a novolac type epoxy resin and the like. Examples of the cyanate resin include a novolac type cyanate resin, a bisphenol A type cyanate resin and the like. The weight average molecular weight of the thermosetting resin used for the heat resistant resin composition is preferably 100 or more and 5, 000 or less. The content of the thermosetting resin used for the heat resistant resin composition is preferably 5 % by mass or more and 55 % by mass or less, based on the total amount of the heat resistant resin composition. The weight average molecular weight of this embodiment is measured by GPC (gel permeation chromatograph) and converted into polystyrene molecular weight.

When an epoxy resin is used, the heat resistant resin composition is not particularly limited, but a curing agent such as a phenol resin or the like may be used together. Examples of the phenol resin include a biphenyl dimethylene type epoxy resin and the like.

The heat resistant film is not particularly limited, but preferably used are heat resistant films having high thermal conductivity. The thermal conductivity mentioned herein refers to the ease of transmission of heat when heat is transmitted from a high temperature side to a low temperature side without moving a substance. Accordingly, heat radiation ability of the semiconductor can be enhanced. It is preferable that the heat resistant film contains an inorganic filler in order to achieve high thermal conductivity. The kind of the inorganic filler is not particularly limited, but for example, silica, alumina, aluminum nitride, boron nitride or the like may be used. Particularly preferably used is spherical silica having an average particle size of 0.01 µm or more and 10 µm or less. From the viewpoint of improvement in the elastic modulus, the average particle size is particularly preferably 0.01 µm or more and 0.1 µm or less, and in view of laser marking property, it is particularly preferably 0.1 µm or more and 0.5 µm or less. When the average particle size is within the above range, an adhesive layer excellent in the thermal time elastic modulus can be obtained. The average particle size of silica is measured in the following manner. Silica is ultrasonically dispersed in water for 1 minute and the average particle size is measured using a laser diffraction type particle size distribution measuring device SALD-7000 (commercially available from Shimadzu Corporation). The value of D50 (integrated number) is taken as the average particle size.

The content of the inorganic filler in the heat resistant film is not particularly limited, but it is preferably not less than 20 % by mass and more preferably not less than 40 % by mass, in view of increase in the elastic modulus at room temperature (23°C). From the viewpoint of increase in the thermal conductivity, it is preferably not less than 25 % by mass and more preferably not less than 50 % by mass. The lower limit of the content of the inorganic filler in the heat resistant film may be, for example, not more than 95 % by mass.

The heat resistant resin composition is not particularly limited, but it may further contain a coupling agent. As the coupling agent, preferably used is a silane coupling agent and particularly preferably used is an epoxy silane coupling agent. The heat resistant resin is dissolved or dispersed in an organic solvent such as methyl ethyl ketone, acetone, toluene, dimethylformamide or the like to be a varnish-like condition.

The resin composition constituting the adhesive layer (hereinafter referred to as the adhesive resin composition) used for the dicing sheet-attached film for forming a semiconductor protection film of this embodiment is not particularly limited as long as the semiconductor element and the heat resistant film are bonded to each other. Preferably used is a resin composition containing the thermosetting component (A) and the inorganic filler (B).

The thermosetting component (A) used for the adhesive resin composition is a resin which is thermally cured alone or a resin which is thermally cured with a curing agent. The thermosetting component (A) is not particularly limited, and those as mentioned above may be used. Among these, preferably used is an epoxy resin, in view of an excellent balance between the heat resistance of the adhesive layer and adhesiveness to the adherend member.

The weight average molecular weight of the thermosetting component (A) is preferably 200 or more and 10,000 or less, and particularly preferably 300 or more and 5,000 or less. When the weight average molecular weight of the thermosetting component (A) is within the above range, both high reactivity during thermal curing and high adhesiveness to the adherend member can be achieved.

The content of the thermosetting component (A) is preferably 1 % by mass or more and 40 % by mass or less, and particularly preferably 3 % by mass or more and 35 % by mass or less, based on the total amount of the adhesive resin composition. When the content of the thermosetting component (A) is within the above range, both the heat resistance and toughness of the adhesive layer after curing can be achieved. The content of the thermosetting component (A) of the adhesive resin composition in the form of a varnish in which constituent components are dissolved or dispersed in a solvent indicates the percentage of the thermosetting component (A) relative to the total amount of the thermosetting component (A), and the inorganic filler (B) and other additives to be used as necessary, excluding the solvent.

As the inorganic filler (B) used for the adhesive resin composition, those as mentioned above may be used. Among these, particularly preferably used is spherical silica having an average particle size of 0.01 µm or more and 10 µm or less. Examples of the silica include precipitated silica, fumed silica, colloidal silica and the like. Among these, preferably used is colloidal silica. Since the level of the contamination with metal in the colloidal silica is lower than that of the precipitated silica and the fumed silica, the use of the colloidal silica allows reducing ionic impurities in the adhesive layer. In addition, since the colloidal silica is formed of a silica dispersed in a solvent in a condition of substantially monodispersion, the blending of the adhesive resin composition into the varnish allows suppressing the agglomeration of the silica.

The average particle size of silica is preferably 0.01 µm or more and 10 µm or less, particularly preferably 0.01 µm or more and 0.1 µm or less from the viewpoint of improvement in the elastic modulus and particularly preferably 0.1 µm or more and 0.5 µm or less in view of laser marking property. When it is within the above range, an adhesive layer excellent in the thermal time elastic modulus can be obtained. A method of measuring the average particle size of silica is as follows. Silica is ultrasonically dispersed in water for 1 minute and the average particle size is measured using a laser diffraction type particle size distribution measuring device SALD-7000 (commercially available from Shimadzu Corporation). The value of D50 (integrated number) is taken as the average particle size.

The content of the inorganic filler (B) is preferably 10 % by mass or more and 60 % by mass or less, and particularly preferably 20 % by mass or more and 40 % by mass or less, based on the total amount of the adhesive resin composition. When the content is within the above range, an adhesive layer excellent in the thermal time elastic modulus can be obtained.

The adhesive resin composition is not particularly limited, but it is preferable that it may further contain a thermoplastic resin. Accordingly, film forming performance of the adhesive resin composition can be improved. Examples of the thermoplastic resin include polyimide resins such as a polyimide resin, a polyetherimide resin and the like; polyamide resins such as a polyamide resin, a polyamideimide resin and the like; acrylic resins; phenoxy resins; and the like. Among these, preferably used are acrylic resins. Since the glass transition temperature of the acrylic resin is low, initial adhesiveness of the adhesive layer can be much improved.

The acrylic resin means an acrylic acid and derivatives thereof. Specific examples include copolymers with other monomers and polymers, for example, acrylate ester such as acrylic acid, methacrylic acid, methyl acrylate, ethyl acrylate and the like; methacrylate ester such as methyl methacrylate, ethyl methacrylate and the like; acrylonitrile, acrylamide and the like.

Among the acrylic resins, preferably used is an acrylic resin having a compound containing an epoxy group, a hydroxyl group, a carboxyl group, a nitrile group and the like (copolymerized monomer component) (particularly, an acrylate ester copolymer). Accordingly, adhesiveness to the adherend such as a semiconductor element or the like can be much improved. Specific examples of the compound having a functional group include glycidyl methacrylate having a glycidylether group, hydroxy methacrylate having a hydroxyl group, carboxyl methacrylate having a carboxyl group, acrylonitrile having a nitrile group and the like.

The content of the compound having a functional group is not particularly limited, but it is preferably 0.5 % by mass or more and 40 % by mass or less, and particularly preferably 5 % by mass or more and 30 % by mass or less, based on the total amount of the acrylic resin. When the content is less than the above lower limit, an effect of improving adhesiveness is reduced in some cases. When it exceeds the above upper limit, an effect of improving workability is reduced in some cases because of excessive adhesiveness.

The glass transition temperature of the thermoplastic resin is not particularly limited, but it is preferably -25°C or more and 120°C or less, particularly preferably -20 °C or more and 60 °C or less, and most preferably -10 °C or more and 50°C or less. When the glass transition temperature is less than the above lower limit, workability is reduced in some cases because of strong adhesiveness of the adhesive layer. When it exceeds the above upper limit, an effect of improving low-temperature adhesiveness is deteriorated in some cases.

The weight average molecular weight of the thermoplastic resin (particularly an acrylic resin) is not particularly limited, but it is preferably not less than 2x10⁴ and particularly preferably 5x10⁴ or more and 100 x10⁴ or less. When the weight average molecular weight is within the range, particularly film forming properties of the adhesive layer can be enhanced.

The content of the thermoplastic resin is not particularly limited, but it is preferably 10 % by mass or more and 30 % by mass or less, and particularly preferably 15 % by mass or more and 25 % by mass or less, based on the total amount of the adhesive resin composition. When the content is less than the above lower limit, an effect of improving film forming performance of the adhesive layer is reduced in some cases. When it exceeds the above upper limit, an effect of improving initial adhesiveness is lowered in some cases.

When an epoxy resin is used as the thermosetting component (A), the epoxy resin is not particularly limited, but it is preferable that it may further contain a curing catalyst which improves the curability of the adhesive resin composition. As the curing catalyst, the same ones as those exemplified in the first embodiment may be used. Preferably used are imidazoles which exhibit both the rapid curability and storage stability of the adhesive resin composition.

The imidazoles are not particularly limited, but the same ones as those exemplified in the first embodiment may be used. Among these, preferably used are 2-phenyl-4,5-dihydroxy methyl imidazole and 2-phenyl-4-methyl-5-hydroxy methyl imidazole, from the viewpoint of an excellent balance between the rapid curability and storage stability of the adhesive resin composition.

The content of the curing catalyst is not particularly limited, but it is preferably 0.01 parts by mass or more and 30 parts by mass or less, and particularly preferably 0.5 parts by mass or more and 10 parts by mass or less, based on 100 parts by mass of the epoxy resin. When the content is within the above range, both the rapid curability and storage stability of the adhesive resin composition can be achieved.

The average particle size of the curing catalyst is not particularly limited, but it is preferably not more than 10 µm and particularly preferably 1 µm or more and 5 µm or less. When the average particle size is within the above range, the rapid curability of the adhesive resin composition can be ensured.

When an epoxy resin is used as the thermosetting component (A), a curing agent such as a phenol resin or the like may also be used together, in addition to the aforementioned compound having a (meth)acryloyl group. The content of the curing agent (particularly, a phenol resin) is not particularly limited, but it is preferably 1 % by mass or more and 20 % by mass or less, and particularly preferably 2 % by mass or more and 10 % by mass or less, based on the total amount of the adhesive resin composition. When the content is less than the above lower limit, the elastic modulus after curing is lowered in some cases. When the content exceeds the above upper limit, the water absorption rate is increased in some cases.

Meanwhile, when an epoxy resin is used as the thermosetting component (A), the content of the curing agent may be determined by calculating an equivalent ratio of the epoxy equivalent and the equivalent of the curing agent. The equivalent ratio of the epoxy equivalent of the epoxy resin and the equivalent of the functional group of the curing agent (for example, a hydroxy equivalent in case of a phenol resin) is preferably 0.3 or more and 3.0 or less, and particularly preferably 0.4 or more and 2.5 or less. When the content is less than the lower limit, the storage stability is deteriorated in some cases. When it exceeds the upper limit, an effect of improving heat resistance is deteriorated in some cases.

The adhesive resin composition is not particularly limited, but it may further contain a coupling agent. Accordingly, this allows providing further improved adhesiveness in the interface between the adhesive layer and the adherend (semiconductor element). As the coupling agent, those as mentioned above may be used. Preferably used is a silane coupling agent excellent in heat resistance of the adhesive agent after curing. The silane coupling agent is not particularly limited, but the same ones as those exemplified in the first embodiment may be used.

The content of the coupling agent is not particularly limited, but it is preferably 0.01 parts by mass or more and 25 parts by mass or less, and particularly preferably 0.5 parts by mass or more and 10 parts by mass or less, based on 100 parts by mass of the thermosetting component (A). When the content is within the above range, an effect of excellent adhesiveness to the adherend (semiconductor element) is obtained.

The adhesive resin composition may contain additives such as a plastic resin, a leveling agent, an antifoaming agent, a coloring agent, organic peroxide or the like, in the ranges in which the object of the present invention is not damaged.

The method for producing a dicing sheet-attached film for forming a semiconductor protection film of this embodiment is not particularly limited, and it can be produced, for example, in the following manner.
First, respective components such as the aforementioned components (A), (B) and other additives are dissolved or dispersed in a solvent such as an organic solvent, for example, methyl ethyl ketone, acetone, toluene, dimethylformamide or the like to be a varnish-like condition.

Next, the varnish of the varnish-like adhesive resin composition is applied to the heat resistant film with a comma coater, a die coater, a gravure coater and the like. The thickness of the adhesive layer is not particularly limited, but it is preferably 3 µm or more and 100 µm or less, and particularly preferably 5 µm or more and 60 µm or less. When the thickness is within the above range, the thickness accuracy of the adhesive layer can be easily controlled.

The adhesive layer in the form of a film is formed on the heat resistant film by forming the adhesive resin composition on the surface of the heat resistant film in the form of a layer, and then drying the film to remove the solvent.

A cover film may be arranged on the surface of the thus-formed adhesive layer in order to protect the protection film-forming layer. As the cover film, the same ones as those explained in the first embodiment may be used.

Thereafter, a dicing sheet-attached film for forming a semiconductor protection film is obtained, which is composed of a dicing sheet, a heat resistant film and an adhesive layer laminated in this order by bonding the dicing sheet to the heat resistant film.

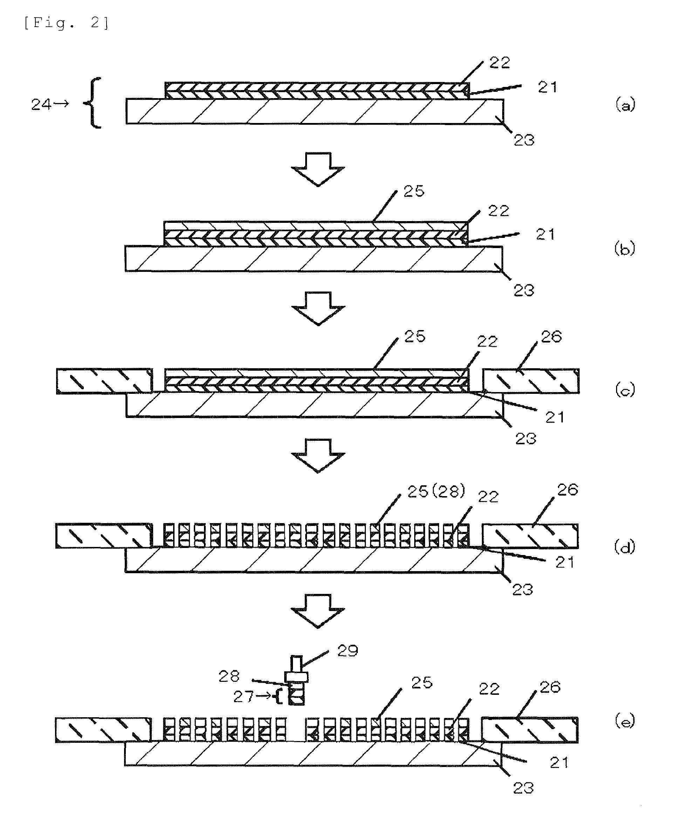

Subsequently, the method for producing a semiconductor device will be described with reference of Fig. 2. Fig. 2 is a flow chart for the production of a semiconductor device. As shown in Fig. 2, a dicing sheet 23, a heat resistant film 21 and an adhesive layer 22 are laminated to form a dicing sheet-attached film for forming a semiconductor protection film 24 which is disposed on a dicer table (not illustrated) (Fig. 2 (a)). The surface of a semiconductor wafer 25 side where a semiconductor element circuit is not formed is put on the adhesive layer 22 in the center, which is then lightly pressed to laminate the semiconductor wafer 25 (Fig. 2 (b)).

Next, wafer rings 26 are arranged on the periphery of the semiconductor wafer 25. At this time, a periphery portion of the dicing sheet 23 is fastened by means of the wafer ring 26 (Fig. 2 (c)). The semiconductor wafer 25 is cut by means of a blade (not illustrated) along with the heat resistant film 21 and the adhesive layer 22, whereby the semiconductor wafer 25 is diced into the respective pieces (Fig. 2 (d)). At this time, the dicing sheet-attached film for forming a semiconductor protection film 24 has a cushioning function, thus preventing the semiconductor wafer 25 from being broken or cracked during cutting of the semiconductor wafer 25. Incidentally, the semiconductor wafer 25 may be attached to the dicing sheet-attached film for forming a semiconductor protection film 24 in advance, and then placed on the dicer table.

Then, ultraviolet light (wavelength: 200 nm or more and 500 nm or less) is irradiated from the dicing sheet 23 side (lower side in Fig. 2 (d)), and the dicing sheet 23 is further expanded with an expanding device (not illustrated) in order to provide certain intervals between the respective diced semiconductor wafers 25 (semiconductor elements 28) and the heat resistant film 21 having the adhesive layer 22 (a semiconductor protection film 27). Then, the semiconductor element 28 is mounted on the substrate using a flip chip bonder. Subsequently, the semiconductor element 28 is picked up with a collet 29, and the semiconductor element 28 having the semiconductor protection film 27 is peeled off from the dicing sheet 23 (Fig. 2 (e)). The semiconductor element 28 having the semiconductor protection film 27 is turned upside down and mounted on the substrate (not illustrated) in a face-down manner.

Here, the dicing sheet 23 is subjected to further curing by an irradiation with ultraviolet light, so that adhesiveness to the heat resistant film 21 becomes lowered. Therefore, when the semiconductor element 28 is picked up, the base film 21 is peeled off from the dicing sheet 23, and the semiconductor protection film 27 is still attached to the respective diced semiconductor elements 28.

Thereafter, the semiconductor element is mounted on the substrate using a flip chip bonder. First, the substrate having the semiconductor element 28 mounted thereon is heated at a temperature or higher (for example, 200 °C or more and 280°C or less) which dissolves bumps for electrically bonding electrode pads of the semiconductor element 28 and electrode pads of the substrate in an oven or the like, whereby the semiconductor element 28 and the substrate are completely bonded. Thereafter, a liquid epoxy resin (an encapsulation resin) also called an underfill material is filled between the semiconductor element 18 and the substrate, and the resulting material is cured. The underfill material is cured and the semiconductor protection film 27 is also thermally cured, whereby a semiconductor device having the semiconductor protection film 27 formed on the semiconductor element 28 is obtained. The obtained semiconductor device is composed of the mounting substrate, the semiconductor element 28 and the semiconductor protection film 27 which are laminated in this order. Incidentally, the underfill material and the semiconductor protection film 27 are thermally cured, and then may be subjected to laser marking.

According to the embodiment, a film for forming a semiconductor protection film excellent in protection ability of the semiconductor element and a semiconductor device having the semiconductor protection film formed by using the film can be obtained.

In Patent Document 1, since a binder polymer component was used for a protection film, there were problems such that the collet traces were attached and scratches were not fully prevented, when a semiconductor element composed of a protection film-forming layer having a low elastic modulus was mounted on a circuit board using a flip chip bonder or the like. Also, in Patent Document 3, by use of a high molecular weight component having a weight average molecular weight of not less than 10x10⁴ as a thermosetting component, there were the same problems. In addition, due to a difference in the linear expansion coefficients between the semiconductor substrate and the chip, the chip was warped and as a result, the reliability was deteriorated.

In this embodiment, by use of the heat resistant film having a high elastic modulus, the collet traces can be prevented from being attached and in the following reflow process, warping of the semiconductor element can be suppressed.

### Third Embodiment

The dicing sheet-attached film for forming a semiconductor element protection film of this embodiment is **characterized in that** a dicing sheet are laminated with a protection film-forming layer formed on one side of the dicing sheet. The protection film-forming layer (film for forming a semiconductor protection film) protects a surface of a semiconductor element mounted on a base material such as a substrate or the like and positioned on the outermost side opposite to the surface mounted on the base material such as a substrate or the like. The resin composition constituting the protection film-forming layer comprises a thermosetting component (A) and an inorganic filler (B), and accordingly protects the semiconductor element so as not to cause cracking or the like. Furthermore, the semiconductor device of this embodiment is a semiconductor device in which a surface of a semiconductor element mounted on a base material such as a substrate or the like and positioned on the outermost side opposite to the surface mounted on said base material such as a substrate or the like is protected by a semiconductor protection film, wherein the semiconductor protection film is composed of a cured product of the aforementioned protection film-forming layer, and it is accordingly possible to prevent collet traces or scratches from being caused when the semiconductor element is mounted on the substrate by means of a flip chip bonder or the like. Furthermore, a semiconductor device with reduced warpage can be obtained. Hereinafter, the dicing sheet-attached film for forming a semiconductor protection film of this embodiment, the semiconductor device and the method for producing a semiconductor device will be described each in detail.

The lower limit of the weight average molecular weight of the resin component in the resin composition constituting the protection film-forming layer (hereinafter referred to as the film resin composition) is preferably not less than 100 and more preferably not less than 200. The upper limit of the weight average molecular weight of the resin component in the film resin composition is preferably not more than 49,000 and more preferably not more than 40,000. When the weight average molecular weight of the resin component is within the above range, it allows the protection film-forming layer to have a high glass transition temperature after curing while maintaining film forming properties.

The film resin composition may contain a thermosetting component (A). As the thermosetting component (A), those as aforementioned above may be used. Among these, preferably used is an epoxy resin in view of the heat resistance and strength. Furthermore, it is preferable that the protection film-forming layer has a high elastic modulus for the purpose of improving protection ability, and accordingly a filler is highly filled. For this reason, tackiness of the film is lost, or the film resin composition becomes fragile. In order to prevent such phenomena, a liquid epoxy resin is preferably used.

The weight average molecular weight of the thermosetting component (A) is preferably 100 or more and 49,000 or less, and particularly preferably 200 or more and 40,000 or less. When the weight average molecular weight of the thermosetting component (A) is within the above range, both high reactivity during thermal curing and high protection ability to the adherend can be achieved. Incidentally, the weight average molecular weight of this embodiment is measured by GPC (gel permeation chromatography) and converted into polystyrene molecular weight.

The content of the thermosetting component (A) is preferably 3 % by mass or more and 35 % by mass or less, and particularly preferably 5 % by mass or more and 20 % by mass or less, based on the total amount of the film resin composition. When the content of the thermosetting component (A) is within the above range, both high elastic modulus and toughness of the protection film-forming layer after curing can be achieved. Incidentally, the content of the thermosetting component (A) of the film resin composition in the form of a varnish in which constituent components are dissolved or dispersed in a solvent indicates the percentage of the thermosetting component (A) relative to the total amount of the thermosetting component (A), the inorganic filler (B) and other additives, excluding the solvent.

When an epoxy resin is used as the thermosetting component (A), a curing agent is preferably contained. Examples of the curing agent include amine curing agents such as: aliphatic polyamines such as diethylenetriamine (DETA), triethylenetetramine (TETA), metaxylylenediamine (MXDA) and the like; aromatic polyamines such as diaminodiphenyl methane (DDM), m-phenylenediamine (MPDA), diaminodiphenylsulphone (DDS) and the like; and polyamine compounds such as dicyandiamide (DICY), organic acid dihydrazide and the like; acid anhydride curing agents such as: alicyclic acid anhydrides (liquid acid anhydrides) such as hexahydrophthalic anhydride (HHPA), methyl tetrahydrophthalic anhydride (MTHPA) and the like; and aromatic acid anhydrides such as trimellitic anhydride (TMA), pyromellitic dianhydride (PMDA), benzophenone tetracarboxylic dianhydride (BTDA) and the like; and phenolic curing agents such as a phenol resin and the like. Among these, preferably used are the phenolic curing agents, and specifically the phenolic curing agents include compounds of: various types of isomers of bisphenols such as bis(4-hydroxy-3,5-dimethyl phenyl)methane (synonym: tetramethyl bisphenol F), 4,4'-sulphonyldiphenol, 4,4'-isopropylidene diphenol (synonym: bisphenol A), bis(4-hydroxyphenyl)methane, bis(2-hydroxyphenyl)methane, (2-hydroxyphenyl) (4-hydroxyphenyl)methane, and a mixture of three of these bisphenols, namely a mixture of bis(4-hydroxyphenyl)methane, bis(2-hydroxyphenyl)methane and (2-hydroxyphenyl)(4-hydroxyphenyl)methane (for example, product name of Bisphenol F-D, commercially available from Honshu Chemical Industry Co., Ltd.) and the like; dihydroxybenzenes such as 1,2-benzendiol, 1,3-benzendiol, 1,4-benzendiol and the like; trihydroxybenzenes such as 1,2,4-benzenetriol and the like; and dihydroxynaphthalene such as 1, 6-dihydroxynaphthalene and the like; and various types of isomers of biphenols such as 2,2'-biphenol, 4,4'-biphenol and the like.

The content of the curing agent (particularly, a phenolic curing agent) is not particularly limited, but it is preferably 1 % by mass or more and 20 % by mass or less, and particularly preferably 2 % by mass or more and 10 % by mass or less, based on the total amount of the film resin composition. When the content is less than the above lower limit, an effect of improving heat resistance is deteriorated in some cases. When it exceeds the above upper limit, the storage stability is deteriorated in some cases.

Meanwhile, when an epoxy resin is used as the thermosetting component (A), the content of the curing agent may be determined by calculating an equivalent ratio of the epoxy equivalent and the equivalent of the curing agent. The equivalent ratio of the epoxy equivalent of the epoxy resin and the equivalent of the functional group of the curing agent (for example, a hydroxy equivalent in case of a phenol resin) is preferably 0.3 or more and 3.0 or less, and particularly preferably 0.4 or more and 2.5 or less. When the content is less than the lower limit, the storage stability is deteriorated in some cases. When it exceeds the upper limit, an effect of improving heat resistance is deteriorated in some cases.

When an epoxy resin is used as the thermosetting component (A), the epoxy resin is not particularly limited, but it is preferable that it may further contain a curing catalyst which improves the curability of the protection film-forming layer. As the curing catalyst, the same ones as those exemplified in the first embodiment may be used. Among these, preferably used are imidazoles which exhibit both the rapid curability and storage stability of the protection film-forming layer.

As the imidazole, the same ones as those exemplified in the first embodiment may be used. Among these, preferably used are 2-phenyl-4,5-dihydroxy methyl imidazole and 2-phenyl-4-methyl-5-hydroxy methyl imidazole, from the viewpoint of an excellent balance between the rapid curability and storage stability of the protection film-forming layer.

The content of the curing catalyst is not particularly limited, but it is preferably 0.01 parts by mass or more and 30 parts by mass or less, particularly preferably 0.3 parts by mass or more and 10 parts by mass or less, based on 100 parts by mass of the epoxy resin. When the content is within the above range, both the rapid curability and storage stability of the protection film-forming layer can be achieved.

The average particle size of the curing catalyst is not particularly limited, but it is preferably not more than 10 µm and particularly preferably 1 µm or more and 5 µm or less. When the average particle size is within the above range, the rapid curability of the protection film-forming layer can be ensured.

The film resin composition may contain an inorganic filler (B). The inorganic filler (B) is not particularly limited, and those as mentioned above may be used. Among these, particularly preferably used is alumina. The elastic modulus of alumina is 4 to 5 times of silica, so that the elastic modulus of the protection film-forming layer after curing can be increased.

It is preferable that the particle size distribution of the inorganic filler (B) has at least one maximum point respectively in the range of 1 to 1,000 nm and in the range of 1,000 to 10,000 nm. Such a filler is easily obtained by mixing fillers having different particle size distributions, but the filler is accordingly filled at a highest density and the content of the filler can be increased. The particle size distribution of the inorganic filler (B) is measured in the following manner. The inorganic filler (B) is ultrasonically dispersed in water for 1 minute and the particle size distribution is measured using a laser diffraction type particle size distribution measuring device SALD-7000 (commercially available from Shimadzu Corporation).

The content of the inorganic filler (B) is preferably 60 % by mass or more and 95 % by mass or less, and particularly preferably 80 % by mass or more and 90 % by mass or less, based on the total amount of the film resin composition. When the content is within the above range, a protection film-forming layer excellent in the thermal time elastic modulus can be obtained.

The film resin composition may contain a coloring agent (C). The coloring agent (C) is not particularly limited, and those as mentioned above may be used. The content of the coloring agent (C) is preferably 0.1 % by mass or more and 10 % by mass or less, and particularly preferably 0.2 % by mass or more and 5 % by mass or less, based on the total amount of the film resin composition. When the content of the coloring agent is less than the above lower limit, coloring is not sufficient and the visibility after laser marking tends to be lowered. When it exceeds the above upper limit, the elastic modulus and heat resistance of the protection film-forming layer may possibly be deteriorated.

The film resin composition is not particularly limited, but it may further contain a coupling agent. Accordingly, this allows providing further improved adhesiveness in the interface between the protection film-forming layer and the adherend (semiconductor element). As the coupling agent, the same ones as those exemplified in the first embodiment may be used. Preferably used is a silane coupling agent excellent in heat resistance of the protection film-forming layer after curing. As the silane coupling agent, the same ones as those exemplified in the first embodiment may be used.

The content of the coupling agent is not particularly limited, but it is preferably 0.01 parts by mass or more and 10 parts by mass or less, and particularly preferably 0.5 parts by mass or more and 10 parts by mass or less, based on 100 parts by mass of the thermosetting component (A). When the content is within the above range, an effect of excellent adhesiveness to the adherend (semiconductor element) is obtained.

The film resin composition may contain additives such as a plastic resin, a leveling agent, an antifoaming agent, organic peroxide or the like, in the ranges in which the object of the present invention is not damaged.

The method for producing a dicing sheet-attached film for forming a semiconductor protection film of this embodiment is not particularly limited, and the film can be produced, for example, in the following manner.
First, respective components such as the aforementioned components (A), (B), (C) and other additives are dissolved or dispersed in a solvent such as an organic solvent, for example, methyl ethyl ketone, acetone, toluene, dimethylformamide or the like to be a varnish-like condition.

Next, the varnish of the varnish-like film resin composition is applied to the base film with a comma coater, a die coater, a gravure coater and the like. As the base film, the same ones as those exemplified in the first embodiment may be used. The thickness of the protection film-forming layer is not particularly limited, but it is preferably 3 µm or more and 100 µm or less, and particularly preferably 5 µm or more and 60 µm or less. When the thickness is within the above range, the thickness accuracy of the protection film-forming layer can be easily controlled.

The protection film-forming layer in the form of a film is formed on the base film by forming the film resin composition on the surface of the base film in the form of a layer, and then drying the film to remove the solvent.

A cover film may be arranged on the surface of the thus-formed protection film-forming layer in order to protect the protection film-forming layer. As the cover film, the same ones as those explained in the first embodiment may be used.

Thereafter, a dicing sheet-attached film for forming a semiconductor protection film is obtained, which is composed of a dicing sheet, a base film and a protection film-forming layer laminated in this order by bonding the dicing sheet to the base film.

The dicing sheet-attached film for forming a semiconductor protection film of this embodiment, as explained in the first embodiment, may be used for the method for producing a semiconductor device (Figs. 1 (a) to (e)) according to the flow chart in Fig. 1.

However, in this embodiment, without an irradiation with ultraviolet light after the dicing process, the dicing sheet 13 is expanded with an expanding device (not illustrated) in order to allow the respective diced semiconductor wafers 15 (semiconductor elements 18) being picked up by means of the collet 19 to provide certain intervals between the semiconductor element 18 and the protection film-forming layer 12 (semiconductor protection film 17) (Fig. 1 (e)).

Herein, adhesiveness of the protection film-forming layer 12 (semiconductor protection film 17) to the base film 11 is adjusted, so that the protection film-forming layer 12 (semiconductor protection film 17) is peeled off from the base film 11 when the semiconductor element 18 is picked up, and the semiconductor protection film 17 is still attached to the respective diced semiconductor elements 18.

Thereafter, as explained in the first embodiment, the semiconductor element 18 having the semiconductor protection film 17 is turned upside down and mounted on the substrate in a face-down manner, and the resulting material is heated in an oven or the like to bond the semiconductor element 18 and the substrate. Thereafter, the underfill material is filled between the semiconductor element 18 and the substrate, and the resulting material is cured. The underfill material is cured and the semiconductor protection film 17 is also thermally cured, whereby a semiconductor device having the semiconductor protection film 17 formed on the semiconductor element 18 is obtained. Incidentally, the underfill material and the semiconductor protection film 17 are thermally cured, and then may be subjected to laser marking.

The elastic modulus at 25°C of the semiconductor protection film 17 after curing is preferably 10 GPa or more and 40 GPa or less. Accordingly, warping of the semiconductor device having the semiconductor protection film 17 formed on the semiconductor element 18 can be reduced. The elastic modulus at 25°C may be determined, for example, by measuring the dynamic viscoelasticity of the semiconductor protection film 17 (protection film-forming layer 12) after curing in a tensile mode under conditions of a temperature elevation rate of 3°C/min and a frequency of 10 Hz using a dynamic viscoelasticity measuring device commercially available from Seiko Instruments Inc. and measuring the storage elastic modulus at 25°C.

According to the embodiment, a film for forming a semiconductor protection film excellent in protection ability of the semiconductor element and a semiconductor device with reduced warpage having the semiconductor protection film formed by using the film can be obtained.

In Patent Document 1, since a binder polymer component was used for a protection film, there were problems such that the collet traces were attached and scratches were not fully prevented, when a semiconductor element composed of a protection film-forming layer having a low elastic modulus were mounted on a circuit board using a flip chip bonder or the like. Also, in Patent Document 3, by use of a high molecular weight component having a weight average molecular weight of not less than 10x10⁴ of as the thermosetting component, there were the similar problems. Furthermore, as a semiconductor element and a semiconductor substrate are thinned, warping of a package has become a problem.

According to this embodiment, by use of an inorganic filler in large quantities, a protection film-forming layer having a high elastic modulus can be obtained. Accordingly, the collet traces and warping of a package can be prevented. Furthermore, by use of a liquid epoxy resin as an epoxy resin, adhesiveness to the semiconductor element can be ensured. Accordingly, a semiconductor device with high reliability can be obtained.

While the preferred embodiments of the present invention have been described above, it should be understood that the disclosures above are presented for the purpose of illustrating the present invention, and various modifications other than that described above are also available.
For example, in the embodiments, the method for producing a face-down type semiconductor device has been described with reference to Figs. 1 and 2. However, the method for producing a semiconductor device of the present invention is not restricted thereto, and for example, the method can also be applied to the manufacture of a semiconductor device of a TSV (through-silicon via) structure in which a plurality of semiconductor elements having through vias and having electrodes formed on a surface opposite to a circuit surface are laminated in a face-up manner.

Furthermore, the film resin compositions of the first embodiment and the third embodiment, and the adhesive resin composition of the second embodiment may be formed in the form of a film by forming a varnish-like resin composition in the form of a layer and drying the varnish to remove the solvent.

The method for producing a semiconductor device in the present invention is not restricted to those illustrated in the embodiments, and the method may comprise, for example, a step of cutting the protection film-forming layer processed into a film substantially at the same size as the semiconductor element, and then directly bonding it to the semiconductor element.

### EXAMPLES

The present invention is now illustrated in detail below with reference to Examples and Comparative Examples. However, the present invention is not restricted to these Examples.

A method of measuring the particle size distribution and the average particle size of silica and alumina used in Examples and Comparative Examples is as follows. Silica and alumina were ultrasonically dispersed in water for 1 minute and the particle size distribution was measured using a laser diffraction type particle size distribution measuring device SALD-7000 (commercially available from Shimadzu Corporation). The value of D50 (integrated number) was taken as the average particle size.

Hereinafter, the weight average molecular weights illustrated in Examples and Comparative Examples were measured by GPC (gel permeation chromatograph) and converted into polystyrene molecular weight. GPC was measured under the conditions of device: high-speed GPC SC-8020 commercially available from Tosoh Corporation, column: TSK-GEL GMHXL-L, temperature: 40°C and solvent: tetrahydrofuran.

### Example 1-1

### 1. Compound (D1) Synthesis of (Meth)acryloyl-Modified Novolac Type Bisphenol A Resin MPN001

A 2-L flask was charged with 500 g of a solution of a novolac type bisphenol A resin (Phenolite LF-4871, commercially available from Dainippon Ink and Chemicals, Inc.) in MEK (methyl ethyl ketone) with a solid content of 60%. After the addition of 1.5 g of tributylamine as a catalyst and 0.15 g of hydroquinone as a polymerization inhibitor, the mixture was heated to 100°C. 180.9 g of glycidyl methacrylate was added dropwise to the mixture over 30 minutes, and the mixture was stirred at 100°C for five hours to obtain a (meth)acryloyl-modified novolac type bisphenol A resin MPN001 (methacryloyl-modification rate: 50%) with a solid content of 74%. The weight average molecular weight of D1 was about 7,000.

### 2. Preparation of Varnish of Film Resin Composition

40.5 % by mass of the methacryloyl-modified novolac type bisphenol A resin MPN001 and 17.4 % by mass of trimethylolpropane tri(meth)acrylate (product name: Lite Ester TMP, commercially available from Kyoeisha Chemical Co., Ltd., weight average molecular weight: 338) as the energy ray curing component (D);
1.5 % by mass of a bisphenol A novolac type epoxy resin (product name: Epiclon N-865, commercially available from Dainippon Ink and Chemicals, Inc.) and 5.0 % by mass of a bisphenol A type epoxy resin (product name: YL-6810, commercially available from Japan Epoxy Resin Co., Ltd., weight average molecular weight: 225) as the thermosetting component (A);
30.0 % by mass of spherical silica (product name: SE2050, commercially available from Admatechs Co., Ltd., average particle size: 500 nm) as the inorganic filler (B);
3.6 % by mass of a phenol novolac resin (product name: PR53647, commercially available from Sumitomo Bakelite Co., Ltd.) as the curing agent; and
2.0 % by mass of 2,2-dimethoxy-1,2-diphenylethane-1-on (product name: Irgacure 651, commercially available from Chiba Specialty Chemicals, Inc.) as the photoinitiator were dissolved in MEK (methyl ethyl ketone, commercially available from Daishin-Chemical Co., Ltd.) to obtain a varnish of a film resin composition with a solid content of 73%. The content of the methacryloyl-modified novolac type bisphenol A resin MPN001 and silica in the varnish of the film resin composition is a value in terms of the solid content.

### 3. Preparation of Film for Forming Semiconductor Protection Film (Protection Film-Forming Layer)

Thereafter, the varnish of the film resin composition was applied to a transparent PET base film (film thickness: 38 µm), and dried at 80°C for 15 minutes to form a film for forming a semiconductor protection film having a thickness of 20 µm. The elastic modulus at 260°C of the obtained film for forming a semiconductor protection film before curing and after an irradiation with ultraviolet light (wavelength: 365 nm) was measured in a tensile mode under conditions of a temperature elevation rate of 3°C/min and a frequency of 10 Hz using a dynamic viscoelasticity measuring device commercially available from Seiko Instruments Inc., and it was 0.27 MPa.

### 4. Preparation of Dicing Sheet-attached Film for Forming Semiconductor Protection Film

A PET cover film was laminated on the film layer for forming a semiconductor protection film of the aforementioned base film-attached film for forming a semiconductor protection film, and then only the base film and the film layer for forming a semiconductor protection film were cut in half while leaving only a portion bonded to the wafer. Thereafter, the base film side of the base film-attached film for forming a semiconductor protection film was bonded to a dicing sheet (a polyethylene film having an adhesive layer formed thereon comprising 100 parts by mass of a copolymer having a weight average molecular weight of 500,000 obtained by copolymerizing 70 % by mass of butyl acrylate and 30 % by mass of 2-ethylhexyl acrylate; and 3 parts by mass of tolylene diisocyanate (Coronate T-100, commercially available from Nippon Polyurethane Co., Ltd.)). Accordingly, a dicing sheet-attached film for forming a semiconductor protection film comprising a dicing sheet, a base film, a film for forming a semiconductor protection film and a cover film laminated in this order was obtained.

### 5. Preparation of Semiconductor Device

A semiconductor device was prepared by the following procedure.

The film for forming a semiconductor protection film of the dicing sheet-attached film for forming a semiconductor protection film with the cover film peeled off therefrom was set to oppose a back surface of a 200 µm-thick 8-inch semiconductor wafer, and these were bonded at a temperature of 60°C to obtain a semiconductor wafer having a dicing sheet-attached film for forming a semiconductor protection film bonded thereto.

Thereafter, the semiconductor wafer having the dicing sheet-attached film for forming a semiconductor protection film bonded thereto was diced (cut) into semiconductor elements having a dimension of 10 mm × 10 mm square by employing a dicing saw under conditions of a spindle rotating speed of 30,000 rpm and a dicing speed of 50 mm/sec. Then, the semiconductor element was exposed with 1,000 mJ/cm² (wavelength: 365 nm) from the side of the dicing sheet using an exposure device. Subsequently, the semiconductor element was pushed up from the back surface of the dicing sheet-attached film for forming a semiconductor protection film to cause a separation of the film for forming a semiconductor protection film from the base film to obtain a semiconductor element having a semiconductor protection film attached thereto.

The semiconductor element having the semiconductor protection film attached thereto (10 mm × 10 mm square, circuit step of element surface: 1 to 5 µm) was mounted on a circuit board of a bismaleimide-triazine resin (circuit step of substrate surface: 5 to 10 µm) coated with a solder resist (product name: AUS308, commercially available from Taiyo Ink Mfg. Co., Ltd.) in a face-down manner, and press-bonded at 130°C with 5N for one second via solder bumps to achieve a temporary adhesion of the semiconductor element to the bismaleimide-triazine circuit board. The bismaleimide-triazine circuit board which was temporarily adhered to the semiconductor element was heated at a temperature of 250°C for 10 seconds. Thereafter, an underfill material was filled between the semiconductor element and the substrate, and the resulting material was cured at 150°C for 2 hours to obtain a semiconductor device (a flip chip package).

### Comparative Example 1-1

A semiconductor device (a flip chip package) was obtained in the same manner as in Example 1, except that compositions of the varnish of the film resin composition were changed to the following.
The energy ray curing component (D) was not used, and 20 % by mass of an acrylate ester copolymer (a butyl acrylate-acrylonitrile-ethyl acrylate-glycidyl methacrylate copolymer, SG-80HDR, commercially available from Nagase Chemtex Corporation, Tg: 10°C, weight average molecular weight: 350,000) as the thermoplastic resin;
19. 6 % by mass of an orthocresol novolac type epoxy resin (EOCN-1020-80, commercially available from Nippon Kayaku Co., Ltd., epoxy equivalent: 200 g/eq) and 29 % by mass of a trifunctional epoxy resin (NC6000, commercially available from Nippon Kayaku Co., Ltd., epoxy equivalent: 200 g/eq) as the thermosetting component (A);
22 % by mass of a liquid phenol compound (MEH-8000H, commercially available from Meiwa Plastic Industries, Ltd., hydroxyl equivalent: 141 g/OH) and 9 % by mass of a solid phenol resin (PR-HF-3, commercially available from Sumitomo Bakelite Co., Ltd., hydroxyl equivalent: 104 g/OH) as the curing agent;
0.1 % by mass of an imidazole compound (2P4MHZ-PW, commercially available from Shikoku Chemicals Corporation) as the curing catalyst; and
0.3 % by mass of γ-glycidoxypropyltrimethoxysilane (KBM403E, commercially available from Shin-Etsu Chemical Co., Ltd.) as the coupling agent were dissolved in methyl ethyl ketone (MEK) to obtain a resin varnish with a resin solid content of 49%.
Incidentally, the elastic modulus at 260°C of the film for forming a semiconductor protection film before curing and after an irradiation with ultraviolet light was not more than 0.01 MPa.

### Evaluation Items and Evaluation Results

### Evaluation of Collet Traces:

When the semiconductor element was pushed up from the back surface of the dicing sheet-attached film for forming a semiconductor protection film to cause a separation of the film for forming a semiconductor protection film from the base film, and the semiconductor element having the semiconductor protection film attached thereto was mounted on the substrate using a flip chip bonder, existence of collet traces was visually evaluated. In the semiconductor protection film having a high elastic modulus at 260°C before curing and after an irradiation with ultraviolet light in Example 1-1, the collet traces were not found. On the other hand, in the semiconductor protection film having a low elastic modulus at 260°C before curing and after an irradiation with ultraviolet light in Comparative Example 1-1, the collet traces were found. When the collet traces were attached to the semiconductor protection film, the product quality as a semiconductor device was deteriorated.

### Example 2-1

### 1. Preparation of Adhesive Resin Varnish

10 parts by weight of an epoxy resin (EOCN-1020-80 (an orthocresol novolac type epoxy resin, weight average molecular weight: 780), commercially available from Nippon Kayaku Co., Ltd., epoxy equivalent: 200 g/eq) as the thermosetting component (A);
78 parts by mass of spherical silica (SE2050, commercially available from Admatechs Co., Ltd., average particle size: 0.5 µm) as the inorganic filler (B);
100 parts by mass of SG-708-6DR (an ethyl acrylate-butyl acrylate-acrylonitrile-hydroxyethyl methacrylate-acrylic acid copolymer, commercially available from Nagase Chemtex Corporation, Tg: 6°C, weight average molecular weight: 500,000) as the (meth)acrylate ester copolymer;
10 parts by mass of a phenoxy resin (JER1256, commercially available from Japan Epoxy Resin Co., Ltd., Tg: 130°C, weight average molecular weight: 50,000) as the thermoplastic resin different from the (meth)acrylate ester copolymer;
10 parts by mass of PR-HF-3 (commercially available from Sumitomo Bakelite Co., Ltd., hydroxyl equivalent: 104 g/OH) as the phenol resin; and
2 parts by mass of γ-glycidoxypropyltrimethoxysilane (KBM403E, commercially available from Shin-Etsu Chemical Co., Ltd.) as the coupling agent were dissolved in methyl ethyl ketone (MEK) to obtain a resin varnish with a resin solid content of 20%.

### 2. Preparation of Film for Forming Semiconductor Protection Film (Protection Film-Forming Layer)

The resin varnish obtained by the above-described method was applied with a comma coater over a polyethylene terephthalate film (Product name: Teijin PUREX Film UH4, commercially available from DuPont Teijin Films Co., Ltd., thickness: 50 µm, elastic modulus at room temperature (23°C): 2.3 GPa, melting point: 258°C, 10 % by mass of titanium dioxide contained as a coloring agent) serving as a heat resistant film, and then the film was dried at 150°C for 3 minutes to form an adhesive layer having a thickness of 10 µm. Thus, a film for forming a semiconductor protection film comprising a heat resistant film and an adhesive layer was obtained.

### 3. Preparation of Dicing Sheet-Attached Film for Forming Semiconductor Protection Film.

A PET cover film was laminated on the adhesive layer of the film for forming a semiconductor protection film comprising the aforementioned heat resistant film and the adhesive layer, and only the heat resistant film and the adhesive layer of the film for forming a semiconductor protection film were cut in half while leaving only a portion bonded to the wafer. Thereafter, the heat resistant film was bonded to a dicing sheet (product name: FSL-N4605, commercially available from Sumitomo Bakelite Co., Ltd.). Accordingly, a dicing sheet-attached film for forming a semiconductor protection film comprising a dicing sheet, a heat resistant film, an adhesive layer and a cover film laminated in this order was obtained.

### 4. Preparation of Semiconductor Device

A semiconductor device was prepared by the following procedure.

The adhesive layer with the cover film peeled off therefrom was set to oppose a back surface of a 200 µm-thick 8-inch semiconductor wafer, and these were bonded at a temperature of 60°C to obtain a semiconductor wafer having a dicing sheet-attached film for forming a semiconductor protection film bonded thereto.

Thereafter, the semiconductor wafer having the dicing sheet-attached film for forming a semiconductor protection film bonded thereto was diced (cut) into semiconductor elements having a dimension of 10 mm × 10 mm square along with the adhesive layer and the heat resistant film of the sheet for forming a semiconductor protection film by employing a dicing saw under conditions of a spindle rotating speed of 30,000 rpm and a dicing speed of 50 mm/sec. Then, the semiconductor element was exposed with 1,000 mJ/cm² (wavelength: 365 nm) from the side of the dicing sheet using an exposure device. Subsequently, the semiconductor element was pushed up from the back surface of the dicing sheet-attached film for forming a semiconductor protection film to cause a separation of the heat resistant film from the dicing sheet to obtain a semiconductor element having a semiconductor protection film attached thereto.

The semiconductor element having the semiconductor protection film attached thereto (10 mm × 10 mm square, circuit step of element surface: 1 to 5 µm) was mounted on a circuit board of a bismaleimide-triazine resin (circuit step of substrate surface: 5 to 10 µm) coated with a solder resist (product name: AUS308, commercially available from Taiyo Ink Mfg. Co., Ltd.) in a face-down manner, and press-bonded at 130°C with 5N for one second via solder bumps to achieve a temporary adhesion of the semiconductor element to the bismaleimide-triazine circuit board. The bismaleimide-triazine circuit board which was temporarily adhered to the semiconductor element was heated at a temperature of 250°C for 10 seconds. Thereafter, an underfill material was filled between the semiconductor element and the substrate, and the resulting material was cured at 150°C for 2 hours to obtain a semiconductor device (a flip chip package).

### Example 2-2

A semiconductor device (a flip chip package) was obtained in the same manner as in Example 2-1, except that the heat resistant film was changed to a film (resin content: 50%, film thickness: 60 µm, elastic modulus at room temperature (23°C): 23 GPa, no melting point (being a thermosetting resin), 1 % by mass of carbon black contained as a coloring agent). The film was obtained by dissolving 15 parts by mass of a novolac type cyanate resin (Primaset PT-50, commercially available from Lonza Japan, weight average molecular weight: about 2,600) as the cyanate resin, 8 parts by mass of a biphenylene dimethylene type epoxy resin (NC-3000P, commercially available from Nippon Kayaku Co., Ltd., weight average molecular weight: 860, epoxy equivalent: 275) as the epoxy resin, 7 parts by mass of a biphenyl dimethylene type phenol resin (MEH-7851-S, commercially available from Meiwa Plastic Industries, Ltd., hydroxyl equivalent: 203) as the phenol resin, and 0.3 parts by mass of an epoxysilane type coupling agent (A-187, commercially available from Nippon Unicar Inc.) as the coupling agent relative to 100 parts by mass of an inorganic filler to be described below in methyl ethyl ketone at an ordinary temperature; adding 20 parts by mass of spherical fused silica SFP-10X (commercially available from Denki Kagaku Kogyo Kabushiki Kaisha, average particle size: 0.3 µm) and 50 parts by mass of spherical fused silica SO-32R (commercially available from Admatechs Co., Ltd., average particle size: 1.5 µm) as the inorganic filler thereto; stirring the resulting mixture for 10 minutes using a high-speed stirrer to prepare a resin varnish which was immersed in a glass woven fabric (a plain-woven base material made of E glass, commercially available from Nitto Boseki Co., Ltd., thickness: 53 µm, warp weaving density: 60/inch, woof weaving density: 47/inch, thermal expansion coefficient at from room temperature (23°C) to 250°C: 6 ppm/°C), and then heating and drying the resulting material.

### Comparative Example 2-1

A semiconductor device (a flip chip package) was obtained in the same manner as in Example 2-1, except that the heat resistant film was changed to a polypropylene film (product name: 40RL-01Z, commercially available from OJI Specialty Paper Co., Ltd., thickness: 40 µm, elastic modulus at room temperature (23°C): 0.7 GPa, melting point: 170°C).

The elastic modulus at room temperature (23°C) of the heat resistant film was measured in a tensile mode under conditions of a temperature elevation rate of 3°C/min and a frequency of 10 Hz using a dynamic viscoelasticity measuring device commercially available from Seiko Instruments Inc.

### Evaluation Items and Evaluation Results

### Evaluation of Solder Reflow Resistance

The semiconductor element was pushed up from the back surface of the dicing sheet-attached film for forming a semiconductor protection film to cause a separation of the heat resistant film from the base film, and the semiconductor element having the semiconductor protection film attached thereto was mounted on the substrate using a flip chip bonder. When the resulting substrate was subjected to solder reflow at 260°C, deterioration and deformation of the heat resistant film of the sheet for forming a semiconductor protection film were visually observed. The semiconductor protection films comprising the heat resistant film having a high melting point in Examples 2-1 and 2-2 were not deformed. On the other hand, in the semiconductor protection film comprising the heat resistant film having a low melting point in Comparative Example 2-1, voids were observed due to deterioration and deformation of the heat resistant film. When voids were formed in the semiconductor protection film, the product quality as a semiconductor device was deteriorated.

### Solder Reflow Resistance

Solder reflow resistance was evaluated by visually observing whether the heat resistant film was deteriorated or deformed after solder reflow.
○: No deterioration and deformation observed for the total 10 films
×: Deterioration and deformation observed for one or more films among 10 films
The results are shown in Table 1.

### Evaluation of Collet Traces:

When the semiconductor element was pushed up from the back surface of the dicing sheet-attached film for forming a semiconductor protection film to cause a separation of the heat resistant film of the film for forming a semiconductor protection film from the dicing sheet, and the semiconductor element having the semiconductor protection film attached thereto was mounted on the substrate using a flip chip bonder, existence of the collet traces was visually evaluated. In the semiconductor protection films comprising the heat resistant film having a high elastic modulus at room temperature (23°C) in Examples 2-1 and 2-2, the collet traces were not found. On the other hand, in the semiconductor protection film comprising the heat resistant film having a low elastic modulus at room temperature (23°C) in Comparative Examples 2-1, the collet traces were found. When the collet traces were attached to the semiconductor protection film, the product quality as a semiconductor device was deteriorated.

### Die Bonding Properties

Die bonding properties were evaluated by visually observing whether the collet traces of the flip chip bonder were remained on the semiconductor protection film after bonding.
○: No collet traces observed for the total 10 films
×: Collet traces observed for one or more films among 10 films
The results are shown in Table 1.

[Table 1]

**Table1**

| | | | Example 2-1 | Example 2-2 | Comp Ex 2-1 |
|---|---|---|---|---|---|
| Heat Resistant Film or the like | | | UH4 | Thermosetting resin Glass woven fabric Film | 40RL-01Z |
| | Tensile elastic modulus [GPa] | | 2.3 | 23 | 0.7 |
| | Melting point [°C] | | 258 | - | 170 |
| Evaluation Results | | Solder reflow resistance | ○ | ○ | × |
| | | Die bonding properties | ○ | ○ | × |

### Example 3-1

### 1. Preparation of Varnish of Film Resin Composition

100 parts by mass of LX-SB10 (a glycidylamine type epoxy resin) (commercially available from Daiso Co., Ltd., epoxy equivalent: 110 g/eq, weight average molecular weight: 291, liquid at an ordinary temperature) and 15 parts by mass of a modified phenoxy resin of YX6954B35 (concentration of a modified phenoxy resin in methyl ethyl ketone: 35 % by mass) (epoxy equivalent: 12,000 g/eq, weight average molecular weight: 39,000, commercially available from Japan Epoxy Resin Co., Ltd.) as the thermosetting component (A);
228 parts by mass of alumina of AC2050-MNA (concentration of spherical alumina in methyl ethyl ketone: 70 % by mass) (commercially available from Admatechs Co., Ltd., average particle size: 0.7 µm, maximum point: 860 nm) and 228 parts by mass of silica of SE2050-LE (concentration of spherical silica in methyl ethyl ketone: 75 % by mass) (commercially available from Admatechs Co., Ltd., average particle size: 0.5 µm, maximum point: 580 nm) as the inorganic filler (B);
15 parts by mass of carbon black of MT-190BK (concentration of carbon black in toluene/3-methoxybutyl acetate: 15 % by mass) (commercially available from Tokushiki Co., Ltd.) as the coloring agent (C);
38 parts by mass of MEH-7500 (a phenol resin) (hydroxyl equivalent: 97 g/OH, commercially available from Meiwa Plastic Industries, Ltd.) as the curing agent;
3.0 parts by mass of γ-glycidoxypropyltrimethoxysilane (KBM403E, commercially available from Shin-Etsu Chemical Co., Ltd.) as the coupling agent;
0.4 parts by mass of an imidazole compound (2PHZ-PW, average particle size: 3.2 µm, commercially available from Shikoku Chemicals Corporation) as the curing catalyst; and
7.3 parts by mass of BYK-361N (commercially available from BYK Chemical Japan Ltd.) as the leveling agent were dissolved in methyl ethyl ketone (MEK) to obtain a varnish of a film resin composition with a resin solid content of 90%.

### 2. Preparation of Film for Forming Semiconductor Protection Film (Protection film-Forming Layer)

Thereafter, the varnish of the film resin composition was applied to a transparent PET base film (film thickness: 38 µm), and dried at 80°C for 15 minutes to form a film for forming a semiconductor protection film having a thickness of 60 µm. Incidentally, the elastic modulus at 25° of the obtained film for forming a semiconductor protection film after curing at 180°C for 2 hours was measured in a tensile mode under conditions of a temperature elevation rate of 3°C/min and a frequency of 10 Hz using a dynamic viscoelasticity measuring device commercially available from Seiko Instruments Inc., and it was 12.0 GPa.

### 3. Preparation of Dicing Sheet-attached Film for Forming Semiconductor Protection Film

A PET cover film was laminated on the aforementioned film for forming a semiconductor protection film, and then only the base film and the film for forming a semiconductor protection film were cut in half while leaving only a portion bonded to the wafer and removing the periphery portion. Thereafter, a dicing sheet (a polyethylene film having an adhesive layer laminated thereon comprising 100 parts by mass of a copolymer having a weight average molecular weight of 500,000 obtained by copolymerizing 70 % by mass of butyl acrylate and 30 % by mass of 2-ethylhexyl acrylate; and 3 parts by mass of tolylene diisocyanate (Coronate T-100, commercially available from Nippon Polyurethane Co. , Ltd.)) was bonded to the base film. Accordingly, a dicing sheet-attached film for forming a semiconductor protection film comprising a dicing sheet, a base film, a film for forming a semiconductor protection film and a cover film laminated in this order was obtained.

### 4. Preparation of Semiconductor Device

A semiconductor device was prepared by the following procedure.

The film for forming a semiconductor protection film with the cover film peeled off therefrom was set to oppose a back surface of a 100 µm-thick 8-inch semiconductor wafer, and these were bonded at a temperature of 60°C to obtain a semiconductor wafer having a dicing sheet-attached film for forming a semiconductor protection film bonded thereto.

Thereafter, the semiconductor wafer having the dicing sheet-attached film for forming a semiconductor protection film bonded thereto was diced (cut) into semiconductor elements having a dimension of 10 mm × 10 mm square by employing a dicing saw under conditions of a spindle rotating speed of 30,000 rpm and a dicing speed of 50 mm/sec. Then, the semiconductor element was pushed up from the back surface of the dicing sheet-attached film for forming a semiconductor protection film to cause a separation of the film for forming a semiconductor protection film from the base film to obtain a semiconductor element having a semiconductor protection film attached thereto.

The semiconductor element having the semiconductor protection film attached thereto (10 mm × 10 mm square × 100 µm thick, circuit step of element surface: 1 to 5 µm) was mounted on a circuit board of a bismaleimide-triazine resin (14 mm × 14 mm square × 135 µm thick, circuit step of substrate surface: 5 to 10 µm) coated with a solder resist (product name: AUS308, commercially available from Taiyo Ink Mfg. Co., Ltd.) in a face-down manner, and press-bonded at 130°C with 5N for one second via solder bumps to achieve a temporary adhesion of the semiconductor element to the bismaleimide-triazine circuit board. The bismaleimide-triazine circuit board which was temporarily adhered to the semiconductor element was heated at a temperature of 250°C for 10 seconds. Thereafter, an underfill material was filled between the semiconductor element and the substrate, and the resulting material was cured at 150°C for 2 hours to obtain a semiconductor device (a flip chip package).

### Example 3-2

A semiconductor device (a flip chip package) was obtained in the same manner as in Example 3-1, except that composition of the varnish of the film resin composition was changed to the following.
244 parts by mass of DAW-05 (spherical alumina) (commercially available from Denki Kagaku Kogyo Kabushiki Kaisha, average particle size: 5 µm, maximum point: 2,800 nm) was used as the inorganic filler (B).
Incidentally, the obtained film for forming a semiconductor protection film was cured at a temperature of 180°C for 2 hours and then the elastic modulus at 25°C thereof was measured, and it was 10.1 GPa.

### Example 3-3

A semiconductor device (a flip chip package) was obtained in the same manner as in Example 3-1, except that compositions of the varnish of the film resin composition were changed to the following.
257 parts by mass of alumina of AC2050-MNA (concentration of spherical alumina in methyl ethyl ketone: 70 % by mass) (commercially available from Admatechs Co., Ltd., average particle size: 0.7 µm, maximum point: 860 nm) and 900 parts by mass of DAW-05 (spherical alumina) (commercially available from Denki Kagaku Kogyo Kabushiki Kaisha, average particle size: 5 µm, maximum point: 2,800 nm) were used as the inorganic filler (B).
Incidentally, the elastic modulus at 25°C of the obtained film for forming a semiconductor protection film after curing was 28.3 GPa.

### Comparative Example 3-1

A semiconductor device (a flip chip package) was obtained in the same manner as in Example 1, except that compositions of the varnish of the film resin composition were changed to the following.
100 parts by mass of LX-SB10 (a glycidylamine type epoxy resin) (commercially available from Daiso Co. , Ltd., epoxy equivalent: 110 g/eq, weight average molecular weight: 291, liquid at an ordinary temperature) and 15 parts by mass of a modified phenoxy resin of YX6954B35 (concentration of a modified phenoxy resin in methyl ethyl ketone: 35 % by mass) (epoxy equivalent: 12,000 g/eq, weight average molecular weight: 39,000, commercially available from Japan Epoxy Resin Co., Ltd.) as the thermosetting component (A);
38 parts by mass of MEH-7500 (a phenol resin) (commercially available from Meiwa Plastic Industries, Ltd., hydroxyl equivalent: 97 g/OH) as the curing agent;
3.0 parts by mass of γ-glycidoxypropyltrimethoxysilane (KBM403E, commercially available from Shin-Etsu Chemical Co., Ltd.) as the coupling agent;
0.4 parts by mass of an imidazole compound (2PHZ-PW, commercially available from Shikoku Chemicals Corporation, average particle size: 3.2 µm) as the curing catalyst; and
7.3 parts by mass of BYK-361N (commercially available from BYK Chemical Japan Ltd.) as the leveling agent were dissolved in methyl ethyl ketone (MEK) to obtain a varnish of a film resin composition with a resin solid content of 90%.
Incidentally, the elastic modulus at 25°C of the film for forming a semiconductor protection film after curing was 3.1 GPa.

### Evaluation Items and Evaluation Results

### Evaluation of Collet Traces

When the semiconductor element was pushed up from the back surface of the dicing sheet-attached film for forming a semiconductor protection film to cause a separation of the film for forming a semiconductor protection film from the dicing sheet, and the semiconductor element having the semiconductor protection film attached thereto was mounted on the substrate using a flip chip bonder, existence of the collet traces was visually evaluated. In the semiconductor protection films having a high content of the inorganic filler in Examples 3-1, 3-2 and 3-3, the collet traces were not found. On the other hand, in the semiconductor protection film comprising having a low content of the inorganic filler in Comparative Example 3-1, the collet traces were found. When the collet traces were attached to the semiconductor protection film, the product quality as a semiconductor device was deteriorated.

### Evaluation of Warping of Semiconductor Device

With respect to the obtained semiconductor device (the flip chip package), a displacement amount in a height direction was measured using a three-dimensional laser measuring equipment with variable temperature (LS150-RT50/5, commercially available from Hitachi Tsuchiura Engineering Co., Ltd.) and the largest value in a displacement difference was defined as a warpage amount of the semiconductor device. The semiconductor device with a warpage amount of 100 µm or less was marked with o, while the semiconductor device with a warpage amount of more than 100 µm was marked with x. The results are shown in Table 2.

[Table 2]

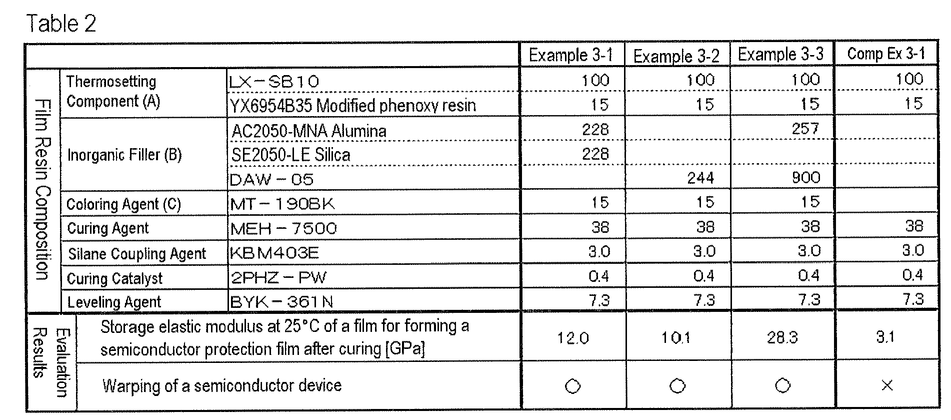

Other embodiments of the present invention are exemplified below.

### 1. First Exemplary Embodiment

[1] A film for forming a semiconductor protection film to be used for protecting a surface of a semiconductor element mounted on a structure such as a substrate or the like and positioned on the outermost side opposite to the surface mounted on said structure, wherein a resin composition constituting the film for forming a semiconductor protection film contains an energy ray curing component (D) and a thermosetting component (A).
[2] The film for forming a semiconductor protection film as set forth in [1], wherein the resin composition constituting said film for forming a semiconductor protection film further contains an inorganic filler (B), and the content of said inorganic filler (B) in the resin composition constituting said film for forming a semiconductor protection film is 10 to 60 % by mass.
[3] The film for forming a semiconductor protection film as set forth in [1] or [2], wherein the resin composition constituting said film for forming a semiconductor protection film further contains a coloring agent (C).
[4] The film for forming a semiconductor protection film as set forth in any one of [1] to [3], wherein the tensile elastic modulus at 260°C of said film for forming a semiconductor protection film before curing is 0.01 to 100 MPa.
[5] The film for forming a semiconductor protection film as set forth in any one of [2] to [4], wherein said inorganic filler (B) contains silica having an average particle size of 1 nm or more and 500 nm or less.
[6] The film for forming a semiconductor protection film as set forth in [5], wherein the average particle size of said silica is 10 nm or more and 30 nm or less.
[7] The film for forming a semiconductor protection film as set forth in any one of [1] to [6], wherein said energy ray curing component (D) contains a compound (D1) having a hydroxyl group or a carboxyl group and a (meth) acryloyl group.
[8] The film for forming a semiconductor protection film as set forth in [7], wherein the weight average molecular weight of said compound (D1) is 200 to 100,000.
[9] The film for forming a semiconductor protection film as set forth in [7] or [8], wherein said compound (D1) is at least one kind selected from the group consisting of a compound (D11) having a dibasic acid introduced into the molecular chain of a (meth)acryloyl-modified epoxy resin having a (meth)acryloyl group introduced into both ends of the epoxy resin by bonding a hydroxyl group in the molecular chain of the (meth)acryloyl-modified epoxy resin to one of the carboxyl groups among the dibasic acids through an ester bond;
   a (meth)acryloyl-modified bisphenol (D12),
   a (meth)acrylic acid polymer (D13) having a carboxyl group and a (meth)acryloyl group, and
   a (meth)acryloyl-modified novolac type phenol resin (D14).
[10] The film for forming a semiconductor protection film as set forth in any one of [7] to [9], wherein said compound (D1) is a compound represented by the above general formula (1) or (2).
[11] The film for forming a semiconductor protection film as set forth in any one of [1] to [10], wherein said film for forming a semiconductor protection film is used for protecting a surface of a semiconductor element opposite to a circuit surface in a face-down type semiconductor device in which the circuit surface of the semiconductor element is directed toward a semiconductor circuit board side.
[12] The film for forming a semiconductor protection film as set forth in any one of [1] to [10], wherein said film for forming a semiconductor protection film is used for protecting a circuit surface of a semiconductor element positioned on the outermost side in a TSV (through-silicon via) type semiconductor device obtained by laminating a plurality of semiconductor elements having through vias and having electrodes formed on a surface opposite to the circuit surface in a face-up manner.
[13] A dicing sheet-attached film for forming a semiconductor protection film, obtained by laminating a dicing sheet with the film for forming a semiconductor protection film as set forth in any one of [1] to [12] on one side of the dicing sheet.
[14] The dicing sheet-attached film for forming a semiconductor protection film as set forth in [13], wherein said dicing sheet and said film for forming a semiconductor protection film are laminated to each other through a base film.
[15] A method for producing a semiconductor device in which a surface of a semiconductor element mounted on a structure such as a substrate or the like and positioned on the outermost side opposite to the surface mounted on said structure is protected by a semiconductor protection film, comprising a step of laminating a dicing sheet with the film for forming a semiconductor protection film as set forth in any one of [1] to [12];
   a step of laminating a semiconductor wafer on a surface of said film for forming a semiconductor protection film opposite to the dicing sheet-laminated surface so as to be in contact with the semiconductor element surface opposite to the surface mounted on said structure;
   a step of dicing said semiconductor wafer into a predetermined size along with said film for forming a semiconductor protection film; and
   a step of obtaining the semiconductor element having the semiconductor protection film attached thereon by peeling off said dicing sheet from said film for forming a semiconductor protection film.
[16] A semiconductor device in which a surface of a semiconductor element mounted on a structure such as a substrate or the like and positioned on the outermost side opposite to the surface mounted on said structure is protected by a semiconductor protection film, wherein said semiconductor protection film is formed from a cured product of the film for forming a semiconductor protection film as set forth in any one of [1] to [12].
[17] A semiconductor device in which a surface of a semiconductor element mounted on a structure such as a substrate or the like and positioned on the outermost side opposite to the surface mounted on said structure is protected by a semiconductor protection film, wherein the semiconductor device is manufactured by the method for producing a semiconductor device as set forth in [15].
[18] The semiconductor device as set forth in [16] or [17], wherein said semiconductor device has a face-down structure in which a circuit surface of a semiconductor element is directed toward a semiconductor circuit board side.
[19] The semiconductor device as set forth in [16] or [17], wherein said semiconductor device has a TSV (through-silicon via) structure in which a plurality of semiconductor elements having through vias and having electrodes formed on a surface opposite to a circuit surface are laminated in a face-up manner.

### 2. Second Exemplary Embodiment

[1] A sheet for forming a semiconductor protection film to be used for protecting a surface of a semiconductor element mounted on a structure such as a substrate or the like and positioned on the outermost side opposite to the surface mounted on said structure, wherein said sheet for forming a semiconductor protection film contains at least an adhesive layer and a heat resistant film, and
   the adhesive layer side of said sheet for forming a semiconductor protection film is bonded to the surface of said semiconductor element opposite to the surface mounted on said substrate.
[2] The sheet for forming a semiconductor protection film as set forth in [1], wherein the tensile elastic modulus at room temperature of said heat resistant film is 2 to 30 GPa.
[3] The sheet for forming a semiconductor protection film as set forth in [1] or [2], wherein the melting point of said heat resistant film is not less than 250°C.
[4] The sheet for forming a semiconductor protection film as set forth in any one of [1] to [3], wherein said heat resistant film has laser marking property.
[5] The sheet for forming a semiconductor protection film as set forth in any one of [1] to [4], wherein a resin composition constituting said heat resistant film contains a coloring agent.
[6] The sheet for forming a semiconductor protection film as set forth in any one of [1] to [5], wherein the resin composition constituting said heat resistant film contains an inorganic filler.
[7] The sheet for forming a semiconductor protection film as set forth in any one of [1] to [6], wherein the resin composition constituting said heat resistant film contains an inorganic filler having high thermal conductivity.
[8] The sheet for forming a semiconductor protection film as set forth in any one of [1] to [7], wherein the resin composition constituting said adhesive layer contains a thermosetting component (A) and an inorganic filler (B).
[9] The sheet for forming a semiconductor protection film as set forth in any one of [1] to [8], wherein the content of said inorganic filler (B) in the resin composition constituting said adhesive layer is 10 to 60 % by mass.
[10] The sheet for forming a semiconductor protection film as set forth in any one of [1] to [9], wherein said sheet for forming a semiconductor protection film is used for protecting a surface of a semiconductor element opposite to a circuit surface in a face-down type semiconductor device in which the circuit surface of the semiconductor element is directed toward a semiconductor circuit board side.
[11] The sheet for forming a semiconductor protection film as set forth in any one of [1] to [9], wherein said sheet for forming a semiconductor protection film is used for protecting a circuit surface of a semiconductor element positioned on the outermost side in a TSV (through-silicon via) type semiconductor device obtained by laminating a plurality of semiconductor elements having through vias and having electrodes formed on a surface opposite to the circuit surface in a face-up manner.
[12] A sheet for forming a semiconductor protection film with a dicing sheet, obtained by laminating a dicing sheet with the sheet for forming a semiconductor protection film as set forth in any one of [1] to [11] on one side of the dicing sheet.
[13] The sheet for forming a semiconductor protection film with a dicing sheet as set forth in [12], wherein said dicing sheet and said sheet for forming a semiconductor protection film are laminated to each other through a base film.
[14] A method for producing a semiconductor device in which a surface of a semiconductor element mounted on a structure such as a substrate or the like and positioned on the outermost side opposite to the surface mounted on said structure is protected by a semiconductor protection film, comprising a step of laminating the sheet for forming a semiconductor protection film as set forth in any one of [1] to [11] with a dicing sheet such that the heat resistant film side in said sheet for forming a semiconductor protection film is come into contact with the dicing sheet;
   a step of laminating a semiconductor wafer on the adhesive layer side of said sheet for forming a semiconductor protection film so as to be in contact with the semiconductor element surface opposite to the surface mounted on said structure;
   a step of dicing said semiconductor wafer into a predetermined size along with said sheet for forming a semiconductor protection film; and
   a step of obtaining the semiconductor element with the semiconductor protection film attached thereon having a heat resistant film by peeling off said dicing sheet from said heat resistant film in said sheet for forming a semiconductor protection film.
[15] A semiconductor device in which a surface of a semiconductor element mounted on a structure such as a substrate or the like and positioned on the outermost side opposite to the surface mounted on said structure is protected by a semiconductor protection film, wherein the semiconductor device is obtained by using the sheet for forming a semiconductor protection film as set forth in any one of [1] to [13].
[16] A semiconductor device in which a surface of a semiconductor element mounted on a structure such as a substrate or the like and positioned on the outermost side opposite to the surface mounted on said structure is protected by a semiconductor protection film, wherein the semiconductor device is manufactured by the method for producing a semiconductor device as set forth in [14].
[17] The semiconductor device as set forth in [15] or [16], wherein said semiconductor device has a face-down structure in which a circuit surface of a semiconductor element is directed toward a semiconductor circuit board side.
[18] The semiconductor device as set forth in [15] or [16], wherein said semiconductor device has a TSV (through-silicon via) structure in which a plurality of semiconductor elements having through vias and having electrodes formed on a surface opposite to a circuit surface are laminated in a face-up manner.

### 3. Third Exemplary Embodiment

[1] A film for forming a semiconductor protection film to be used for protecting a surface of a semiconductor element mounted on a structure such as a substrate or the like and positioned on the outermost side opposite to the surface mounted on said structure, wherein a resin composition constituting said film for forming a semiconductor protection film contains a thermosetting component (A) and an inorganic filler (B).
[2] The film for forming a semiconductor protection film as set forth in [1], wherein the content of said inorganic filler (B) in the resin composition constituting said film for forming a semiconductor protection film is 60 to 95 % by mass.
[3] The film for forming a semiconductor protection film as set forth in [1] or [2], wherein the resin composition constituting said film for forming a semiconductor protection film further contains a coloring agent (C).
[4] The film for forming a semiconductor protection film as set forth in any one of [1] to [3], wherein the elastic modulus at 25°C of said film for forming a semiconductor protection film after curing is 10 to 40 MPa.
[5] The film for forming a semiconductor protection film as set forth in any one of [1] to [4], wherein said inorganic filler (B) has at least one maximum point respectively in the range of 1 to 1, 000 nm and in the range of 1,000 to 10,000 nm.
[6] The film for forming a semiconductor protection film as set forth in any one of [1] to [5], wherein said inorganic filler (B) is alumina.
[7] The film for forming a semiconductor protection film as set forth in any one of [1] to [6], wherein said thermosetting component (A) contains an epoxy resin.
[8] The film for forming a semiconductor protection film as set forth in any one of [1] to [7], wherein said thermosetting component (A) contains a liquid epoxy resin.
[9] The film for forming a semiconductor protection film as set forth in any one of [1] to [8], wherein said film for forming a semiconductor protection film is used for protecting a surface of said semiconductor element opposite to a circuit surface of said semiconductor element in a face-down type semiconductor device in which the circuit surface of the semiconductor element is directed toward a semiconductor circuit board side.
[10] The film for forming a semiconductor protection film as set forth in any one of [1] to [9], wherein said film for forming a semiconductor protection film is used for protecting a circuit surface of a semiconductor element positioned on the outermost side in a TSV (through-silicon via) type semiconductor device obtained by laminating a plurality of semiconductor elements having through vias and having electrodes formed on a surface opposite to the circuit surface in a face-up manner.
[11] A dicing sheet-attached film for forming a semiconductor protection film, obtained by laminating a dicing sheet with the film for forming a semiconductor protection film as set forth in any one of [1] to [10] on one side of the dicing sheet.
[12] The dicing sheet-attached film for forming a semiconductor protection film as set forth in [11], wherein said dicing sheet and said film for forming a semiconductor protection film are laminated to each other through a base film.
[13] A method for producing a semiconductor device in which a surface of a semiconductor element mounted on a structure such as a substrate or the like and positioned on the outermost side opposite to the surface mounted on said structure is protected by a semiconductor protection film, comprising a step of laminating a dicing sheet with the film for forming a semiconductor protection film as set forth in any one of [1] to [10];
   a step of laminating a semiconductor wafer on a surface of said film for forming a semiconductor protection film opposite to the dicing sheet-laminated surface so as to be in contact with the semiconductor element surface opposite to the surface mounted on said structure;
   a step of dicing said semiconductor wafer into a predetermined size along with said film for forming a semiconductor protection film; and
   a step of obtaining the semiconductor element having the semiconductor protection film attached thereon by peeling off said dicing sheet from said film for forming a semiconductor protection film.
[14] A semiconductor device in which a surface of a semiconductor element mounted on a structure such as a substrate or the like and positioned on the outermost side opposite to the surface mounted on said structure is protected by a semiconductor protection film, wherein said semiconductor protection film is formed from a cured product of the film for forming a semiconductor protection film as set forth in any one of [1] to [10].
[15] A semiconductor device in which a surface of a semiconductor element mounted on a structure such as a substrate or the like and positioned on the outermost side opposite to the surface mounted on said structure is protected by a semiconductor protection film, wherein the semiconductor device is manufactured by the method for producing a semiconductor device as set forth in [13].
[16] The semiconductor device as set forth in [14] or [15], wherein said semiconductor device has a face-down structure in which a circuit surface of a semiconductor element is directed toward a semiconductor circuit board side.
[17] The semiconductor device as set forth in [14] or [15], wherein said semiconductor device has a TSV (through-silicon via) structure in which a plurality of semiconductor elements having through vias and having electrodes formed on a surface opposite to a circuit surface are laminated in a face-up manner.

According to the present invention, a semiconductor device having a film for forming a semiconductor protection film excellent in protection ability of a semiconductor element and a semiconductor protection film using the film is obtained, so that the semiconductor device is suitable as a face-down type semiconductor device having a structure such that a semiconductor element is exposed, such as µBGA, CSP or the like, and a TSV type semiconductor device obtained by laminating a plurality of semiconductor elements having through vias and having electrodes formed on a surface opposite to a circuit surface in a face-up manner.

## Claims

1. A dicing sheet-attached film for forming a semiconductor protection film to be used for protecting a semiconductor element mounted on a base material and positioned on the outermost side, comprising a protection film-forming layer composed of a resin composition and protecting a surface of said semiconductor element opposite to the surface mounted on said base material, and a dicing sheet laminated on said protection film-forming layer.

2. The dicing sheet-attached film for forming a semiconductor protection film as set forth in claim 1, wherein said protection film-forming layer contains at least a thermosetting component (A).

3. The dicing sheet-attached film for forming a semiconductor protection film as set forth in claim 1 or 2, wherein said protection film-forming layer contains at least an inorganic filler (B), and the content of said inorganic filler (B) is 10 % by mass or more and 95 % by mass or less, based on the total amount of the protection film-forming layer.

4. The dicing sheet-attached film for forming a semiconductor protection film as set forth in any one of claims 1 to 3, wherein said protection film-forming layer contains a coloring agent (C).

5. The dicing sheet-attached film for forming a semiconductor protection film as set forth in any one of claims 1 to 4, wherein the weight average molecular weight of a resin component in said protection film-forming layer is 200 or more and 49,000 or less.

6. The dicing sheet-attached film for forming a semiconductor protection film as set forth in any one of claims 1 to 5, wherein said protection film-forming layer contains an energy ray curing component (D).

7. The dicing sheet-attached film for forming a semiconductor protection film as set forth in claim 6, wherein said energy ray curing component (D) contains a compound (D1) having a hydroxyl group or a carboxyl group and a (meth)acryloyl group.

8. The dicing sheet-attached film for forming a semiconductor protection film as set forth in claim 7, wherein the weight average molecular weight of said compound (D1) is 200 or more and 30,000 or less.

9. The dicing sheet-attached film for forming a semiconductor protection film as set forth in claim 7 or 8, wherein said compound (D1) is at least one kind selected from the group consisting of a compound (D11) having a dibasic acid introduced into the molecular chain of a (meth)acryloyl-modified epoxy resin having a (meth)acryloyl group introduced into both ends of the epoxy resin by bonding a hydroxyl group in the molecular chain of the (meth)acryloyl-modified epoxy resin to one of the carboxyl groups among the dibasic acids through an ester bond;
a (meth)acryloyl-modified bisphenol (D12),
a (meth)acrylic acid polymer (D13) having a carboxyl group and a (meth)acryloyl group, and
a (meth)acryloyl-modified novolac type phenol resin (D14).

10. The dicing sheet-attached film for forming a semiconductor protection film as set forth in any one of claims 7 to 9, wherein said compound (D1) is a compound represented by the following general formula (1) or (2),

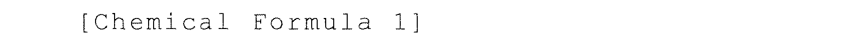

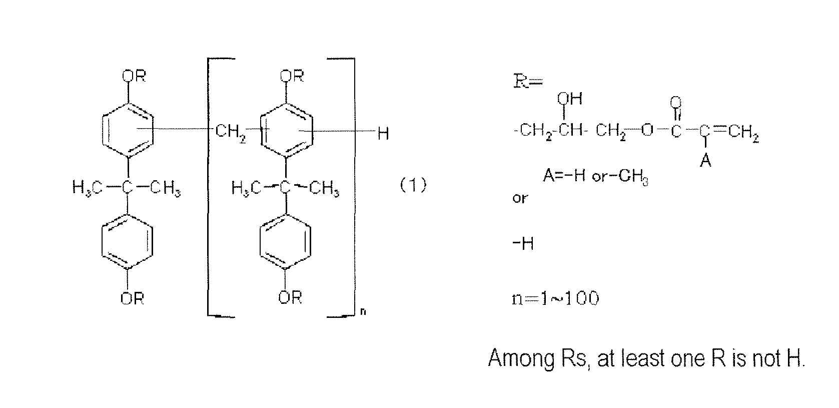

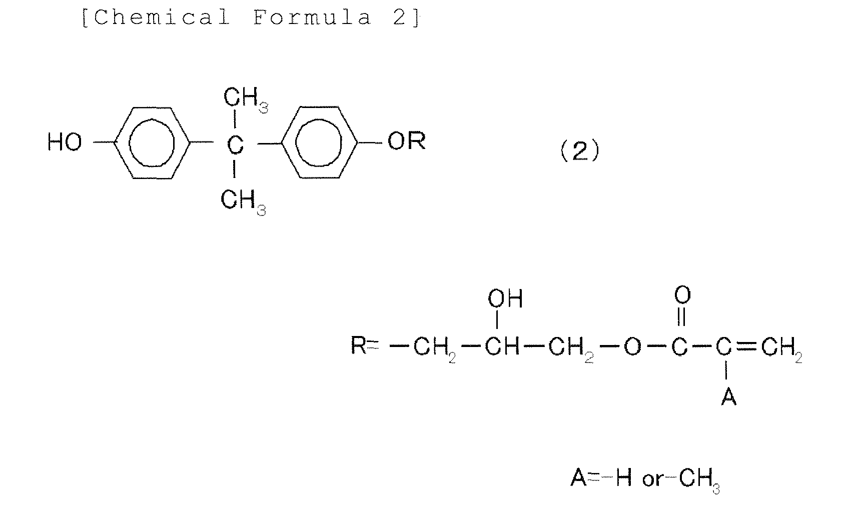

11. The dicing sheet-attached film for forming a semiconductor protection film as set forth in any one of claims 1 to 10, wherein said protection film-forming layer contains an inorganic filler (B), and the content of said inorganic filler (B) is 10 % by mass or more and 60 % by mass or less, based on the total amount of the protection film-forming layer.

12. The dicing sheet-attached film for forming a semiconductor protection film as set forth in claim 11, wherein said inorganic filler (B) contains silica having an average particle size of 1 nm or more and 500 nm or less.

13. The dicing sheet-attached film for forming a semiconductor protection film as set forth in any one of claims 1 to 12, wherein the elastic modulus at 260°C of said protection film-forming layer before curing is 0.01 MPa or more and 100 MPa or less, as measured at a frequency of 10 Hz using a dynamic viscoelasticity measuring device.

14. The dicing sheet-attached film for forming a semiconductor protection film as set forth in any one of claims 1 to 4, wherein said protection film-forming layer is obtained by laminating at least an adhesive layer with a heat resistant film, and said adhesive layer is bonded to a surface of said semiconductor element opposite to the surface mounted on said base material.

15. The dicing sheet-attached film for forming a semiconductor protection film as set forth in claim 14, wherein the elastic modulus at room temperature (23°C) of said heat resistant film is 2 GPa or more and 30 GPa or less, as measured at a frequency of 10 Hz using a dynamic viscoelasticity measuring device.

16. The dicing sheet-attached film for forming a semiconductor protection film as set forth in claim 14 or 15, wherein the melting point of said heat resistant film is not less than 250°C.

17. The dicing sheet-attached film for forming a semiconductor protection film as set forth in any one of claims 14 to 16, wherein said heat resistant film has laser marking property.

18. The dicing sheet-attached film for forming a semiconductor protection film as set forth in any one of claims 14 to 17, wherein said heat resistant film contains a coloring agent.

19. The dicing sheet-attached film for forming a semiconductor protection film as set forth in any one of claims 14 to 18, wherein said heat resistant film contains an inorganic filler.

20. The dicing sheet-attached film for forming a semiconductor protection film as set forth in claim 19, wherein said inorganic filler has high thermal conductivity.

21. The dicing sheet-attached film for forming a semiconductor protection film as set forth in any one of claims 14 to 20, wherein said adhesive layer contains a thermosetting component (A) and an inorganic filler (B).

22. The dicing sheet-attached film for forming a semiconductor protection film as set forth in claim 20, wherein the content of said inorganic filler (B) is 10 % by mass or more and 60 % by mass or less, based on the total amount of the adhesive layer.

23. The dicing sheet-attached film for forming a semiconductor protection film as set forth in any one of claims 1 to 4, wherein said protection film-forming layer contains at least an inorganic filler (B), and the content of said inorganic filler (B) is 60 % by mass or more and 95 % by mass or less, based on the total amount of the protection film-forming layer.

24. The dicing sheet-attached film for forming a semiconductor protection film as set forth in claim 23, wherein the elastic modulus at 25°C of said protection film-forming layer after curing is 10 GPa or more and 40 GPa or less, as measured at a frequency of 10 Hz using a dynamic viscoelasticity measuring device.

25. The dicing sheet-attached film for forming a semiconductor protection film as set forth in claim 23 or 24, wherein said inorganic filler (B) has at least one maximum point respectively in the range of 1 to 1,000 nm and in the range of 1,000 to 10,000 nm.

26. The dicing sheet-attached film for forming a semiconductor protection film as set forth in any one of claims 23 to 25, wherein said inorganic filler (B) is alumina.

27. The dicing sheet-attached film for forming a semiconductor protection film as set forth in any one of claims 23 to 26, wherein said protection film-forming layer contains at least a thermosetting component (A), and the weight average molecular weight of said thermosetting component (A) contained in said protection film-forming layer is not more than 49,000.

28. The dicing sheet-attached film for forming a semiconductor protection film as set forth in claim 27, wherein said thermosetting component (A) contains an epoxy resin.

29. The dicing sheet-attached film for forming a semiconductor protection film as set forth in claim 27 or 28, wherein said thermosetting component (A) contains a liquid epoxy resin.

30. The dicing sheet-attached film for forming a semiconductor protection film as set forth in any one of claims 1 to 29, wherein said protection film-forming layer is used for protecting a surface of said semiconductor element opposite to a circuit surface of said semiconductor element in a face-down type semiconductor device in which the circuit surface of said semiconductor element is directed toward a semiconductor circuit board side.

31. The dicing sheet-attached film for forming a semiconductor protection film as set forth in any one of claims 1 to 30, wherein said dicing sheet-attached film for forming a semiconductor protection film is used for protecting a semiconductor element positioned on the outermost side in a TSV (through-silicon via) type semiconductor device obtained by laminating a plurality of semiconductor elements having through vias and having electrodes formed on a surface opposite to a circuit surface in a face-up manner.

32. The dicing sheet-attached film for forming a semiconductor protection film as set forth in any one of claims 1 to 31, wherein a base film is interposed between said protection film-forming layer and said dicing sheet.

33. A method for producing a semiconductor device having a semiconductor protection film on a surface of a semiconductor element mounted on a base material and positioned on the outermost side opposite to the surface mounted on said base material, comprising:
laminating a semiconductor wafer on said protection film-forming layer side of the dicing sheet-attached film for forming a semiconductor protection film as set forth in any one of claims 1 to 32 having a protection film-forming layer composed of said semiconductor protection film and a dicing sheet so as to be in contact with the semiconductor element surface opposite to the surface mounted on said base material;
dicing said semiconductor wafer into a predetermined size along with said protection film-forming layer; and
obtaining said semiconductor element having said semiconductor protection film formed thereon by peeling off said dicing sheet from said protection film-forming layer.

34. The method for producing a semiconductor device as set forth in claim 33, further comprising mounting said semiconductor element having said semiconductor protection film formed thereon on said base material.

35. The method for producing a semiconductor device as set forth in claim 34, in which said mounting step comprises a reflow process for carrying out solder reflow at a temperature of 200°C or more and 280°C or less.

36. The method for producing a semiconductor device as set forth in claim 34 or 35, further comprising bonding said semiconductor element mounted on said base material to said base material by means of an encapsulation resin in said mounting, in which, in said bonding, a thermosetting component contained in said protection film-forming layer is cured along with said encapsulation resin.

37. A semiconductor device manufactured by the method for producing a semiconductor device as set forth in any one of claims 33 to 36.
